# EUROPEAN PATENT APPLICATION

(11) **EP 4 772 922 A1**
(43) Date of publication of application: **08.07.2026**
(21) Application number: 24858382.5
(22) Date of filing: 20.08.2024
(51) Int. Cl.: G02B 6/42

(54) **OPTICAL MODULE**

(30) Priority: 28.08.2023 CN 202311089253; 02.11.2023 CN 202311452391; 08.01.2024 CN 202420046936 U
(71) Applicant: Hisense Broadband Multimedia Technologies Co., Ltd., Economic and Technical Development Zone Qingdao Shandong 266555 (CN)
(72) Inventor: WANG, Xinnan, Qingdao, Shandong 266555 (CN); ZHANG, Jiaao, Qingdao, Shandong 266555 (CN); MU, Jianwei, Qingdao, Shandong 266555 (CN)
(74) Representative: Casalonga
(86) International application number: PCT/CN2024/113397
(87) International publication number: WO 2025/044839

(57) **Abstract**

An optical module is disclosed, and includes a circuit board, where the circuit board includes a first metal surface layer, a second metal surface layer, and a first metal intermediate layer. Gold fingers are provided on the first metal surface layer and provided with spring contacts, and include high-frequency signal gold fingers. A gap is provided on one side of the gold fingers. A first metal intermediate layer is located below the first metal surface layer, and a first insulating support layer is provided between the first metal intermediate layer and the first metal surface layer. A metal layer is absent from the first metal intermediate layer within a projection area of the high-frequency signal gold fingers to form a hollowed-out area. A first insulating support layer within the projection area on one side of the high-frequency signal gold fingers is hollowed out, to form a first groove.

## Description

This application claims priority to Chinese Patent Application No. 202311089253.6, filed with the China National Intellectual Property Administration on August 28, 2023, priority to Chinese Patent Application No. 202420046936.7, filed with the China National Intellectual Property Administration on January 8, 2024, and priority to Chinese Patent Application No. 202311452391.6, filed with the China National Intellectual Property Administration on November 2, 2023, which are incorporated herein by reference in their entirety.

### FIELD OF THE INVENTION

The present disclosure relates to the field of optical fiber communication technology, and in particular, to an optical module.

### BACKGROUND OF THE INVENTION

Optical modules are typically pluggable optical modules, that is, gold fingers of the optical module need to be inserted into spring contacts of a cage to implement pluggable connection between the optical module and a host computer.

### SUMMARY OF THE INVENTION

In one aspect, embodiments of the present disclosure provide an optical module, and the optical module includes:
a circuit board;
where gold fingers are formed at one end of the circuit board, the gold fingers are configured to transmit electrical signals, and the gold fingers include first gold fingers and second gold fingers; and the circuit board includes:
a first metal surface layer, located on an upper surface of the circuit board and provided with the first gold fingers, where surfaces of the first gold fingers are configured to connect to first spring contacts to implement electrical connection, a gap is provided on one side of the first gold fingers, and the first gold fingers include high-frequency signal gold fingers;
a second metal surface layer, located on a lower surface of the circuit board and provided with the second gold fingers; and
a first metal intermediate layer, located between the first metal surface layer and the second metal surface layer and located below the first metal surface layer, wherein a first insulating support layer is provided between the first metal intermediate layer and the first metal surface layer, a metal layer is absent from the first metal intermediate layer within a projection area of the high-frequency signal gold fingers, and a first insulating support layer within the projection area on one side of the high-frequency signal gold fingers is hollowed out;
the first gold fingers are arranged along a width direction of the circuit board to form a first row of gold fingers, the first row of gold fingers is configured to be electrically connected to a first row of metal spring contacts on a first side wall of a host computer to transmit the electrical signals; the first row of metal spring contacts include the spring contacts;
the second gold fingers are arranged along the width direction of the circuit board to form a second row of gold fingers, the second row of gold fingers are configured to be electrically connected to the second row of metal spring contacts on a second side wall of the host computer to transmit the electrical signals; the first side wall and the second side wall are two opposite side walls of the host computer, where surfaces of the first row of gold fingers and the second row of gold fingers have a height difference, and a spacing between the first row of metal spring contacts and the second row of metal spring contacts is less than a thickness of the circuit board;
the first gold fingers are provided with first contacts, the first contacts are configured to contact with first spring contacts; the second gold fingers are provided with second contacts, the second contacts are configured to contact with second spring contacts of the second row of metal spring contacts; and the first contacts and the second contacts are arranged in a staggered manner, such that the first spring contacts and the second spring contacts are staggered.

In another aspect, an embodiment of the present disclosure provides an optical module, and the optical module includes:
a circuit board, where
the circuit board includes:
   a first metal surface layer, located on an upper surface of the circuit board and provided with gold fingers, where surfaces of the gold fingers are configured to connect to spring contacts to implement electrical connection; a gap is provided on one side of the gold fingers; and the gold fingers include high-frequency signal gold fingers;
   a second metal surface layer, located on a lower surface of the circuit board; and
   a first metal intermediate layer, located between the first metal surface layer and the second metal surface layer and below the first metal surface layer, where a first insulating support layer is provided between the first metal intermediate layer and the first metal surface layer, a metal layer is absent from the first metal intermediate layer within a projection area of the high-frequency signal gold fingers, and a first insulating support layer within the projection area on one side of the high-frequency signal gold fingers is hollowed out.

### BRIEF DESCRIPTION OF THE DRAWINGS

To more clearly illustrate the technical solution in the embodiments of the present disclosure, the accompanying drawings that need to be used in the description of the embodiments or the prior art will be briefly introduced below. Apparently, the accompanying drawings in the description below merely illustrate some embodiments of the present disclosure. Those of ordinary skill in the art may also derive other accompanying drawings from these accompanying drawings without creative efforts.
FIG. 1 is a partial architecture diagram of an optical communication system provided according to some embodiments;
FIG. 2 is a partial structural diagram of a host computer provided according to some embodiments;
FIG. 3 is a structural diagram of an optical module provided according to some embodiments;
FIG. 4 is an exploded view of an optical module provided according to some embodiments;
FIG. 5 is a first assembly diagram of spring contacts and a circuit board provided according to some embodiments;
FIG. 6 is a cross-sectional view of a first assembly diagram of spring contacts and a circuit board provided according to some embodiments;
FIG. 7 is a second assembly diagram of spring contacts and a circuit board provided according to some embodiments;
FIG. 8 is a cross-sectional view of a second assembly diagram of spring contacts and a circuit board provided according to some embodiments;
FIG. 9 is a cross-sectional view of a third assembly diagram of spring contacts and a circuit board provided according to some embodiments;
FIG. 10 is a structural diagram of a circuit board provided according to some embodiments;
FIG. 11 is an exploded view of a circuit board provided according to some embodiments;
FIG. 12 is a structural diagram of a circuit board where a first metal surface layer is removed provided according to some embodiments;
FIG. 13 is a structural diagram of another circuit board where a first metal surface layer is removed provided according to some embodiments;
FIG. 14 is a schematic diagram of simulated reflection loss results of high-frequency signal gold fingers provided according to some embodiments;
FIG. 15 is a schematic diagram of simulated loss results of high-frequency signal gold fingers provided according to some embodiments;
FIG. 16 is a structural schematic diagram of TDR simulation of high-frequency signal gold fingers provided according to some embodiments;
FIG. 17 is a first structural schematic diagram of a circuit board in an optical module provided according to an embodiment of the present disclosure;
FIG. 18 is an enlarged view of a first row of gold fingers in an optical module provided according to an embodiment of the present disclosure;
FIG. 19 is a second structural schematic diagram of a circuit board in an optical module provided according to an embodiment of the present disclosure;
FIG. 20 is an enlarged view of a second row of gold fingers in an optical module provided according to an embodiment of the present disclosure;
FIG. 21 is a perspective structural diagram of gold fingers in an optical module provided according to an embodiment of the present disclosure;
FIG. 22 is a structural diagram of a first row of gold fingers on a first surface in an optical module provided according to an embodiment of the present disclosure;
FIG. 23 is a structural diagram of a second row of gold fingers on a second surface in an optical module provided according to an embodiment of the present disclosure;
FIG. 24 is a comparative structural diagram of a first row of gold fingers and a second row of gold fingers in an optical module provided according to an embodiment of the present disclosure;
FIG. 25 is a first lateral view of a front end of a circuit board in an optical module provided according to an embodiment of the present disclosure;
FIG. 26 is a second lateral view of a front end of a circuit board in an optical module provided according to an embodiment of the present disclosure;
FIG. 27 is another perspective structural diagram of gold fingers in an optical module provided according to an embodiment of the present disclosure;
FIG. 28 is yet another perspective structural diagram of gold fingers in an optical module provided according to an embodiment of the present disclosure;
FIG. 29 is a partial structural diagram of an optical module provided according to some embodiments of the present disclosure;
FIG. 30 is a schematic diagram of a signal principle of an optical module provided according to some embodiments of the present disclosure;
FIG. 31 is a block diagram of switching between different electrical signal modes in an optical module provided according to some embodiments of the present disclosure;
FIG. 32 is a schematic diagram of a signal trace between gold fingers and a digital signal processor in an optical module provided according to some embodiments of the present disclosure;
FIG. 33 is a first top layer routing diagram of a circuit board in an optical module provided according to some embodiments of the present disclosure;
FIG. 34 is an inner layer routing diagram of a circuit board in an optical module provided according to some embodiments of the present disclosure;
FIG. 35 is a top view of routing of a circuit board in an optical module provided according to some embodiments of the present disclosure;
FIG. 36 is a top view of partial routing of a circuit board in an optical module provided according to some embodiments of the present disclosure;
FIG. 37 is a second top layer routing diagram of a circuit board in an optical module provided according to some embodiments of the present disclosure; and
FIG. 38 is a bottom layer routing diagram of a circuit board in an optical module provided according to some embodiments of the present disclosure.

### DETAILED DESCRIPTION OF THE EMBODIMENTS

In optical communication technology, in order to establish information transmission between information processing devices, it is necessary to load information onto light and use the propagation of light to implement the transmission of information. The light loaded with information is an optical signal. When the optical signal propagates in information transmission devices, the loss of optical power can be reduced, such that high-speed, long-distance, and low-cost information transmission can be implemented. The information that can be processed by the information processing devices exists in the form of electrical signals. Optical network units/gateways, routers, switches, mobile phones, computers, servers, tablet computers, and televisions are common information processing devices, while optical fibers and optical waveguides are common information transmission devices.

Optical modules enable the conversion between optical signals and electrical signals from the information processing devices and the information transmission devices. For example, an optical signal input or an optical signal output of an optical module is connected to an optical fiber, and an electrical signal input or an electrical signal output of the optical module is connected to an optical network unit; a first optical signal from the optical fiber is transmitted to the optical module, and the optical module converts the first optical signal into a first electrical signal and transmits the first electrical signal to the optical network unit; and a second electrical signal from the optical network unit is transmitted to the optical module, and the optical module converts the second electrical signal into a second optical signal and transmits the second optical signal to the optical fiber. Since the information processing devices can be interconnected via an electrical signal network, at least one type of information processing device needs to be directly connected to the optical module, and not all types of information processing devices need to be directly connected to the optical module. The information processing device directly connected to the optical module is referred to as a host computer of the optical module.

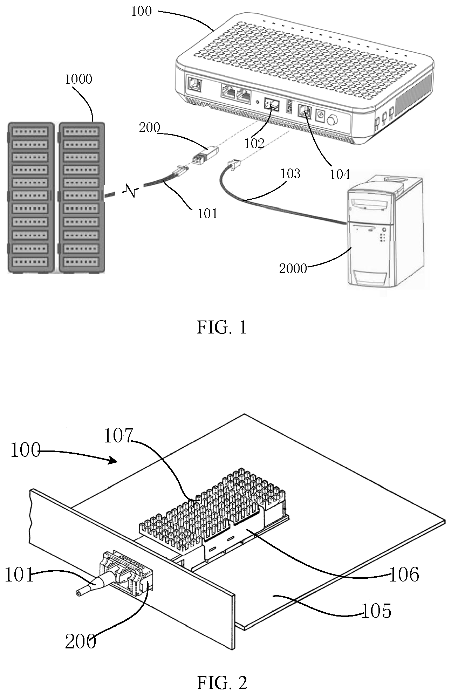

FIG. 1 is a partial architecture diagram of an optical communication system according to some embodiments. As shown in FIG. 1, the optical communication system locally includes a remote information processing device 1000, a local information processing device 2000, a host computer 100, an optical module 200, an optical fiber 101, and a network cable 103.

One end of the optical fiber 101 extends toward the remote information processing device 1000, and the other end of the optical fiber 101 is connected to an optical interface of the optical module 200. An optical signal can undergo total reflection in the optical fiber 101. The propagation of the optical signal in the total reflection direction enables it to nearly maintain original optical power. The optical signal undergoes multiple total reflections in the optical fiber 101 to transmit an optical signal from the remote information processing device 1000 to the optical module 200 or to propagate light from the optical module 200 to the remote information processing device 1000, thereby implementing long-distance and low-power-loss information transmission.

The number of optical fibers 101 may be one or more (two or more). The optical fiber 101 and the optical module 200 may be movably connected in a pluggable manner or fixedly connected.

The host computer 100 is provided with an optical module interface 102. The optical module interface 102 is configured to be connected to the optical module 200, thereby establishing a unidirectional/bidirectional electrical signal connection between the host computer 100 and the optical module 200. The host computer 100 is configured to provide a data signal to the optical module 200, receive a data signal from the optical module 200, or monitor and control a working state of the optical module 200.

The host computer 100 is provided with an external electrical interface, such as a universal serial bus (USB) interface or a network cable interface 104. The external electrical interface can be connected to the electrical signal network. For example, the network cable interface 104 is configured to be connected to the network cable 103, thereby establishing a unidirectional/bidirectional electrical signal connection between the host computer 100 and the network cable 103.

Optical network units (ONUs), optical line terminals (OLTs), optical network terminals (ONTs), and data center servers are common host computers.

One end of the network cable 103 is connected to the local information processing device 2000, and the other end of the network cable 103 is connected to the host computer 100, thereby establishing an electrical signal connection between the local information processing device 2000 and the host computer 100 via the network cable 103.

For example, a third electrical signal sent by the local information processing device 2000 is transmitted to the host computer 100 via the network cable 103. The host computer 100 generates a second electrical signal based on the third electrical signal. The second electrical signal from the host computer 100 is transmitted to the optical module 200. The optical module 200 converts the second electrical signal into a second optical signal and transmits the second optical signal to the optical fiber 101. The second optical signal is transmitted through the optical fiber 101 to the remote information processing device 1000.

For example, a first optical signal from the remote information processing device 1000 is propagated through the optical fiber 101. The first optical signal from the optical fiber 101 is transmitted to the optical module 200. The optical module 200 converts the first optical signal into a first electrical signal and transmits the first electrical signal to the host computer 100. The host computer 100 generates a fourth electrical signal based on the first electrical signal and transmits the fourth electrical signal to the local information processing device 2000.

The optical module is a tool to implement the conversion between optical signals and electrical signals. During the conversion between the optical signals and the electrical signals, the information remains unchanged, and the encoding and decoding methods for the information may vary.

FIG. 2 is a partial structural diagram of a host computer according to some embodiments. To clearly show the connection relationship between the optical module 200 and the host computer 100, FIG. 2 shows only the structure of the host computer 100 related to the optical module 200. As shown in FIG. 2, the host computer 100 further includes a PCB circuit board 105 provided in a shell, a cage 106 provided on the surface of the PCB circuit board 105, a heat sink 107 provided on the cage 106, and an electrical connector provided inside the cage 106 (not shown in the figure). The heat sink 107 has a protruding structure to increase the heat dissipation area. A fin-shaped structure is a common protruding structure.

The optical module 200 is inserted into the cage 106 of the host computer 100, and the optical module 200 is fixed by the cage 106. Heat generated by the optical module 200 is conducted to the cage 106 and then diffused through the heat sink 107. After the optical module 200 is inserted into the cage 106, the electrical interface of the optical module 200 is connected to the electrical connector inside the cage 106.

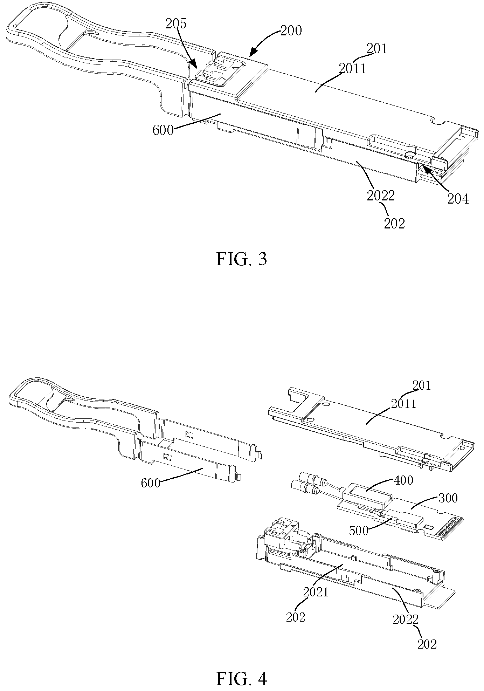

FIG. 3 is a structural diagram of an optical module according to some embodiments. FIG. 4 is an exploded view of an optical module according to some embodiments. As shown in FIG. 3 and FIG. 4, the optical module 200 includes a shell, and a circuit board 300, an optical emission component 400 and an optical reception component 500 which are arranged in the shell. However, the present disclosure is not limited thereto. In some embodiments, the optical module 200 includes either the optical emission component 400 or the optical reception component 500.

The shell includes an upper shell 201 and a lower shell 202, where the upper shell 201 covers the lower shell 202 to form the shell with an opening 204 and an opening 205; and the outer contour of the shell is generally square.

In some embodiments, the lower shell 202 includes a bottom plate 2021 and two lower side plates 2022 located at two sides of the bottom plate 2021 and perpendicular to the bottom plate 2021; and the upper shell 201 includes a cover plate 2011, where the cover plate 2011 is covered on the two lower side plates 2022 of the lower shell 202 to form the shell.

In some embodiments, the lower shell 202 includes a bottom plate 2021 and two lower side plates 2022 located at two sides of the base plate 2021 and perpendicular to the bottom plate 2021; and the upper shell 201 includes a cover plate 2011 and two upper side plates located at two sides of the cover plate 2011 and perpendicular to the cover plate 2011, where the two upper side plates and the two lower side plates 2022 are combined to ensure that the upper shell 201 is covered on the lower shell 202.

The direction of a connecting line between the opening 204 and the opening 205 may be consistent with the length direction of the optical module 200 or may be inconsistent with the length direction of the optical module 200. For example, the opening 204 is located at the end of the optical module 200 (the right end of FIG. 3), and the opening 205 is also located at the end of the optical module 200 (the left end of FIG. 3). Alternatively, the opening 204 is located at the end of the optical module 200, and the opening 205 is located at the side of the optical module 200. The opening 204 is an electrical interface, and gold fingers of the circuit board 300 extend out from the electrical interface and are inserted into the electrical connector of the host computer; and the opening 205 is an optical port, which is configured to be connected to the optical fiber 101 such that the optical fiber 101 is connected to the optical emission component 400 and/or the optical reception component 500 in the optical module 200.

The assembly method of combining the upper shell 201 with the lower shell 202 is adopted, such that the circuit board 300, the optical emission component 400, the optical reception component 500 and other components can be conveniently mounted in the shell, and these components can be packaged by the upper shell 201 and the lower shell 202 for protection. In addition, when the circuit board 300, the optical emission component 400, the optical reception component 500 and other components are assembled, it is convenient for the deployment of positioning parts, heat dissipation parts and electromagnetic shielding parts of these devices, and is conducive to the automatic production.

In some embodiments, the upper shell 201 and the lower shell 202 are made of metal materials, which is conducive to electromagnetic shielding and heat dissipation.

In some embodiments, the optical module 200 further includes an unlocking component 600 located outside its shell. The unlocking component 600 is configured to implement a fixed connection between the optical module 200 and the host computer, or to release the fixed connection between the optical module 200 and the host computer.

For example, the unlocking component 600 is located outside the two lower side plates 2022 of the lower shell part 202, and includes a clamping component that matches the cage 106 of the host computer. When the optical module 200 is inserted into the cage 106, the optical module 200 is fixed in the cage 106 by the clamping component of the unlocking component 600; and when the unlocking component 600 is pulled, the clamping component of the unlocking component 600 moves accordingly, such that the connection relationship between the clamping component and the host computer is changed to release the fixation of the optical module 200 to the host computer, thereby pulling out the optical module 200 from the cage 106.

The circuit board 300 includes circuit traces, electronic components, and chips, where the electronic components and the chips are connected together through the circuit traces according to the circuit design to implement functions such as power supply, electrical signal transmission, and grounding. The electronic components may include, for example, capacitors, resistors, transistors, and metal-oxide-semiconductor field-effect transistors (MOSFETs). The chips may include, for example, microcontroller units (MCUs), laser driving chips, transimpedance amplifiers (TIAs), limiting amplifiers, clock and data recovery (CDR) chips, power management chips, and digital signal processing (DSP) chips.

The circuit board 300 is generally a rigid circuit board. The rigid circuit board can also implement the bearing effect because of its relatively hard material, for example, the rigid circuit board can smoothly carry the above-mentioned electronic components and chips. The rigid circuit board can also be conveniently inserted into the electrical connector in the cage of the host computer.

The circuit board 300 further includes gold fingers formed on its end surface, where the gold fingers consist of a plurality of pins that are independent of each other. The circuit board 300 is inserted into the cage 106 and is connected to the electrical connector in the cage 106 via the gold finger. The gold fingers may be provided only on the surface of one side of the circuit board 300 (such as the upper surface shown in FIG. 4), or may be provided on the surfaces of the upper and lower sides of the circuit board 300 to provide more pins. The gold fingers are configured to establish an electrical connection with the host computer to implement power supply, grounding, inter-integrated circuit (I2C) signal transmission, data signal transmission, and the like.

Certainly, flexible circuit boards may also be used in some optical modules. The flexible circuit boards are generally used in conjunction with rigid circuit boards as a supplement to the rigid circuit boards.

The optical emission component 400 and/or the optical reception component 500 are located on one side of the circuit board 300 away from the gold fingers; in some embodiments, the optical emission component 400 and the optical reception component 500 are physically separated from the circuit board 300 and then are electrically connected to the circuit board 300 via corresponding flexible circuit boards or electrical connectors; and in some embodiments, the optical emission component and/or the optical reception component may be directly provided on the circuit board 300, may be provided on the surface of the circuit board, or may be provided on a side of the circuit board.

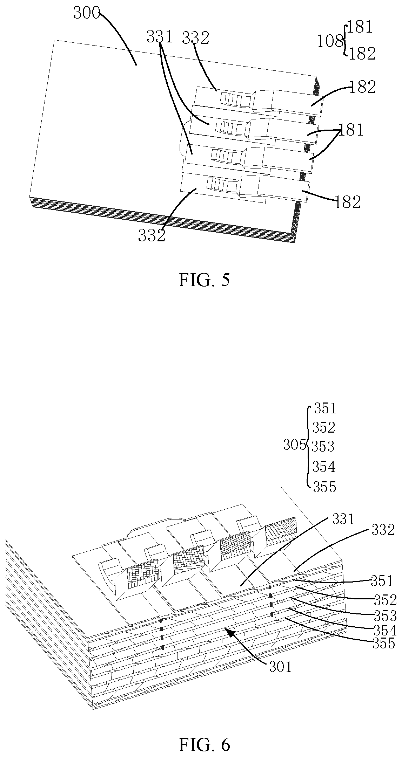

FIG. 5 is a first assembly diagram of spring contacts and a circuit board provided according to some embodiments. FIG. 6 is a cross-sectional view of a first assembly diagram of spring contacts and a circuit board provided according to some embodiments. As shown in FIG. 5 and FIG. 6, the cage 106 includes the spring contacts 108, the spring contacts 108 are arranged corresponding to the gold fingers of the optical module 200, and the spring contacts 108 include first spring contacts 181 and second spring contacts 182, where two of the first spring contacts 181 are respectively located between two of the second spring contacts 182.

The circuit board 300 includes a first metal surface layer, a second metal surface layer, and a metal intermediate layer assembly 305, where the first metal surface layer is located on an upper surface of the circuit board 300, the second metal surface layer is located on a lower surface of the circuit board 300, and the metal intermediate layer assembly 305 is located between the first metal surface layer and the second metal surface layer. Any two adjacent metal layers of the circuit board 300 are connected via an insulating support layer, where the insulating support layer is made of resin. Gold fingers may be formed on the circuit board 300.

In some examples, the gold fingers may include first gold fingers and second gold fingers. The first metal surface layer is provided with the first gold fingers, where the first gold fingers may include high-frequency signal gold fingers 331 and ground gold fingers 332, and the high-frequency signal gold fingers 331 are each located between the ground gold fingers 332. The upper surface of the circuit board 300 and the lower surface of the circuit board 300 are arranged opposite to each other.

After the optical module 200 is inserted into the cage 106, the first spring contacts 181 are connected to the high-frequency signal gold fingers 331, and the second spring contacts 182 are connected to the ground gold fingers 332, so as to implement connection between the spring contacts 108 and the gold fingers. After the first spring contacts 181 are connected to the high-frequency signal gold fingers 331, thickness of the high-frequency signal gold fingers 331 at the contact increases, and a stub is generated between the high-frequency signal gold fingers 331 and the first spring contacts 181, resulting in impedance discontinuity of the high-frequency signal gold fingers 331. This enables signal reflection when electrical signals are transmitted to the high-frequency signal gold fingers 331, thereby affecting the transmission quality of the electrical signals.

To mitigate the impedance discontinuity of the high-frequency signal gold fingers 331 caused by connection between the first spring contacts 181 and the high-frequency signal gold fingers 331, as shown in FIG. 6, in some embodiments, the circuit board 300 includes a hollowed-out area 301. In other words, the metal intermediate layer assembly 305 within the projection area of the high-frequency signal gold fingers 331, starting from the first layer from top to bottom in sequence, has at least one layer without a metal layer, to form the hollowed-out area 301. The hollowed-out area 301 is provided, such that the metal layer moves downward, and a dielectric thickness between the high-frequency signal gold finger 331 and the reference ground (the metal layer serves as the reference ground) increases. According to the principle of impedance, the great dielectric thickness indicates the great impedance, thereby mitigating the impedance discontinuity of the high-frequency signal gold finger 331.

In some embodiments, the metal intermediate layer assembly 305 includes a first metal intermediate layer 351, and the first metal intermediate layer 351 within the projection area of the high-frequency signal gold fingers 331 has no metal layer, to form the hollowed-out area 301.

In some embodiments, the metal intermediate layer assembly 305 further includes at least one metal intermediate layer, and at least one metal intermediate layer within the projection area of the high-frequency signal gold fingers 331, starting from the first layer from top to bottom in sequence, has at least one layer without a metal layer, to form the hollowed-out area 301. The metal intermediate layer, starting from the first layer from top to bottom in sequence, has at least one layer without a metal layer, meaning that the metal intermediate layer has no metal layer from top to bottom in sequence. For example, the metal layer is absent from the first layer, and the metal layer is present beyond the second layer; or the metal layer is absent from the first layer and the second layer, and the metal layer is beyond the third layer.

To further mitigate the impedance discontinuity of the high-frequency signal gold fingers 331, in some embodiments, the metal intermediate layer assemblies 305 within the projection area of the high-frequency signal gold fingers 331 and within the projection area on one side of the high-frequency signal gold fingers 331, starting from the first layer from top to bottom in sequence, has at least one layer without a metal layer, to form the hollowed-out area 301. One side of the high-frequency signal gold finger 331 may be an area between the high-frequency signal gold finger 331 and the ground gold finger 332, or an area between the two adjacent high-frequency signal gold fingers 331.

In some embodiments, the metal intermediate layer assemblies 305 within the projection area of the high-frequency signal gold fingers 331 and in the projection areas on both sides of the high-frequency signal gold fingers 331, starting from the first layer from top to bottom in sequence, have at least one layer without a metal layer, to form the hollowed-out area 301.

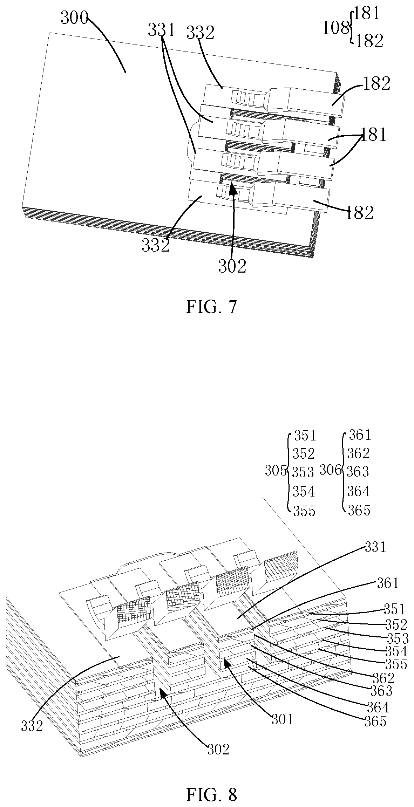

FIG. 7 is a second assembly diagram of spring contacts and a circuit board provided according to some embodiments. FIG. 8 is a cross-sectional view of a second assembly diagram of spring contacts and a circuit board provided according to some embodiments. As shown in FIG. 7 and FIG. 8, in some embodiments, the circuit board 300 further includes a first groove 302, that is, a first insulating support layer within the projection area on one side of the high-frequency signal gold fingers 331 is hollowed out to form the first groove 302, where the projection area on one side of the high-frequency signal gold finger 331 where the first groove 302 is located and the projection area on one side of the high-frequency signal gold finger 331 forming the hollowed-out area 301 are a same side projection area of the high-frequency signal gold finger 331. The first groove 302 is provided such that the proportion of air in the dielectric between the high-frequency signal gold finger 331 and the reference ground increases, and the dielectric constant of resin is greater than that of air. According to the principle of impedance, the small dielectric constant indicates the great impedance, thereby mitigating the impedance discontinuity of the high-frequency signal gold finger 331.

The hollowed-out area increases the dielectric thickness between the high-frequency signal gold finger and the reference ground, thereby increasing the impedance of the high-frequency signal gold finger to mitigate the impedance discontinuity of the high-frequency signal gold finger caused by connection between the spring contact and the high-frequency signal gold finger. The first groove reduces the dielectric constant of the dielectric between the high-frequency signal gold finger and the reference ground, further increasing the impedance of the high-frequency signal gold finger and further mitigating the impedance discontinuity of the high-frequency signal gold finger caused by connection between the spring contact and the high-frequency signal gold finger.

One side of the high-frequency signal gold finger 331 refers to an area between the high-frequency signal gold finger 331 and the ground gold finger 332. The first insulating support layer within the projection area between the high-frequency signal gold finger 331 and the ground gold finger 332 is hollowed out to form the first groove 302. One side of the high-frequency signal gold finger 331 refers to an area between two high-frequency signal gold fingers 331. The first insulating support layer within the projection area between the two high-frequency signal gold fingers 331 is hollowed out to form the first groove 302.

In some embodiments, all insulating support layers above the first metal layer within the projection area on one side of the high-frequency signal gold finger 331 are hollowed out to form the first groove 302, that is, the first groove 302 is provided within the projection area on one side of the high-frequency signal gold finger 331, and the bottom surface of the first groove 302 is the metal layer that is the first metal layer. All the insulating support layers above the first metal layer within the projection area on one side of the high-frequency signal gold finger 331 are hollowed out, increasing the dielectric thickness between the high-frequency signal gold finger 331 and the reference ground, thereby increasing the impedance and mitigating the impedance discontinuity of the high-frequency signal gold finger 331. The metal layer at the bottom surface of the first groove 302 and the first metal layer within the projection area of the high-frequency signal gold finger 331 are located on a same layer of the circuit board 300.

In some embodiments, the metal intermediate layer assembly 305 includes the first metal intermediate layer 351, where the metal layer is absent from the projection area of the high-frequency signal gold finger 331 and the first metal intermediate layer 351 within the projection area on one side of the high-frequency signal gold finger 331, to form the hollowed-out area 301. The first insulating support layer 361 and the second insulating support layer 362 within the projection area on one side of the high-frequency signal gold finger 331 are hollowed out to form the first groove 302. The second insulating support layer 362 is connected to the first metal intermediate layer 351 and is located below the first metal intermediate layer 351.

In some embodiments, the metal intermediate layer assembly 305 further includes at least one metal intermediate layer, where the at least one metal intermediate layer within the projection area of the high-frequency signal gold finger 331 and f the projection area on one side of the high-frequency signal gold finger 331, starting from the first layer from top to bottom in sequence, has at least one layer without a metal layer, to form the hollowed-out area 301, that is, within the projection area of the high-frequency signal gold finger 331 and within the projection area on one side of the high-frequency signal gold finger 331, the metal layer is absent between the high-frequency signal gold finger 331 and the metal layer at the bottom surface of the first groove 302, to form the hollowed-out area 301; and all the insulating support layers above the first metal layer within the projection area on one side of the high-frequency signal gold finger 331 are hollowed out to form the first groove 302, that is, the first groove 302 is respectively provided on both sides of the high-frequency signal gold finger 331, and the metal layer at the bottom surface of the first groove 302 is the first metal layer. The first metal layer within the projection area of the high-frequency signal gold finger and the first metal layer within the projection area on one side of the high-frequency signal gold finger are located on the same layer of the circuit board.

For example, the metal intermediate layer assembly 305 further includes a second metal intermediate layer 352, where the metal layer is absent from the first metal intermediate layer 351 and the second metal intermediate layer 352 within the projection area of the high-frequency signal gold finger 331 and within the projection area on one side of the high-frequency signal gold finger 331, to form the hollowed-out area 301. The first insulating support layer 361, the second insulating support layer 362, and the third insulating support layer 363 within the projection area on one side of the high-frequency signal gold finger 331 are hollowed out to form the first groove 302. The third insulating support layer 363 is connected to the second metal intermediate layer 352 and is located below the second metal intermediate layer 352.

For example, the metal intermediate layer assembly further includes a third metal intermediate layer 353, a fourth metal intermediate layer 354, and a fifth metal intermediate layer 355, where the metal layer is absent from the first metal intermediate layer 351, the second metal intermediate layer 352, the third metal intermediate layer 353, and the fourth metal intermediate layer 354 within the projection area of the high-frequency signal gold finger 331 and within the projection area on one side of the high-frequency signal gold finger 331, to form the hollowed-out area 301. However, the metal layer is present in the fifth metal intermediate layer 355 within the projection area of the high-frequency signal gold finger 331 and within the projection area on one side of the high-frequency signal gold finger 331; the first insulating support layer 361, the second insulating support layer 362, the third insulating support layer 363, a fourth insulating support layer 364, and a fifth insulating support layer 365 within the projection area on one side of the high-frequency signal gold finger 331 are hollowed out to form the first groove 302, that is, the bottom surface of the first groove 302 is the fifth metal intermediate layer 355. The fourth insulating support layer 364 is connected to the third metal intermediate layer 353 and is located below the third metal intermediate layer 353; the fifth insulating support layer 365 is connected to the fourth metal intermediate layer 354 and is located below the fourth metal intermediate layer 354; the fifth metal intermediate layer 335 serves as both the first metal layer within the projection area of the high-frequency signal gold finger 331 and the first metal layers within the projection areas on both sides of the high-frequency signal gold finger 331.

In some embodiments, the first insulating support layers within the projection areas on both sides of the high-frequency signal gold finger 331 are hollowed out to form the first groove 302. In other words, the first insulating support layers within the projection area between any two adjacent high-frequency signal gold fingers 331, as well as within the projection area between the high-frequency signal gold finger 331 and the ground gold finger 332, are hollowed out to form the first groove 302.

In some embodiments, all the insulating support layers above the first metal layers within the projection areas on both sides of the high-frequency signal gold finger 331 are hollowed out to form the first groove 302.

When the thickness of the first groove 302 is great, the dielectric thickness between the high-frequency signal gold finger 331 and the reference ground is great and the impedance of the high-frequency signal gold finger 331 is great. To further increase the impedance of the high-frequency signal gold finger 331, in some embodiments, the thickness of the first groove 302 is half the thickness of the circuit board 300. When the thickness of the first groove 302 is half the thickness of the circuit board 300, this not only further increases the impedance of the high-frequency signal gold finger 331, but also ensures the bending strength of the circuit board 300.

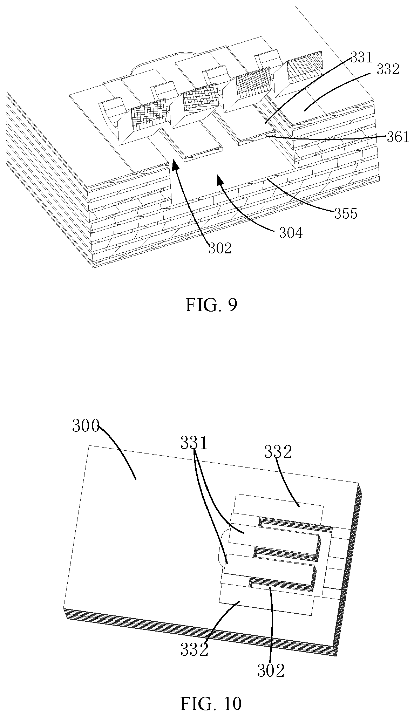

FIG. 9 is a cross-sectional view of a third assembly diagram of spring contacts and a circuit board provided according to some embodiments. As shown in FIG. 9, in some embodiments, the circuit board 300 further includes a second groove 304, that is, the insulating support layers above the first metal layer within the projection area of the high-frequency signal gold finger 331, except for the first insulating support layers, are hollowed out to form the second groove 304. The second groove 304 is provided, such that the dielectric between the high-frequency signal gold finger 331 and the reference ground is entirely replaced from resin to air. Since the dielectric constant of the resin is greater than that of air, according to the principle of impedance, the small dielectric constant indicates the great impedance, thereby mitigating the impedance discontinuity of the high-frequency signal gold finger 331.

The hollowed-out area increases the dielectric thickness between the high-frequency signal gold finger and the reference ground, increasing the impedance of the high-frequency signal gold finger to mitigate the impedance discontinuity of the high-frequency signal gold finger caused by connection between the spring contact and the high-frequency signal gold finger; the first groove reduces the dielectric constant of the dielectric between the high-frequency signal gold finger and the reference ground, further increasing the impedance of the high-frequency signal gold finger, and further mitigating the impedance discontinuity of the high-frequency signal gold finger caused by connection between the spring contact and the high-frequency signal gold finger; and the second groove further reduces the dielectric constant of the dielectric between the high-frequency signal gold finger and the reference ground, further increasing the impedance of the high-frequency signal gold finger and further mitigating the impedance discontinuity of the high-frequency signal gold finger caused by connection between the spring contact and the high-frequency signal gold finger.

In some embodiments, all insulating support layers above the first metal layer within the projection area of the high-frequency signal gold fingers 331, except for the first insulating support layer, are hollowed out to form the second groove 304, that is, the insulating support layer is absent between the first insulating support layer within the projection area of the high-frequency signal gold fingers 331 and the metal layer at the bottom surface of the first groove 302 (namely, the fifth metal intermediate layer 335), and only the gap is present. All the insulating support layers above the first metal layer within the projection area of the high-frequency signal gold finger 331, except for the first insulating support layer, are hollowed out, increasing the proportion of air in the dielectric between the high-frequency signal gold fingers 331 and the reference ground, reducing the dielectric constant, increasing the impedance, thereby mitigating the impedance discontinuity of the high-frequency signal gold fingers 331.

In some embodiments, the metal intermediate layer assembly 305 includes the first metal intermediate layer 351, where the metal layer is absent from the projection area of the high-frequency signal gold finger 331 and the first metal intermediate layer 351 within the projection area on one side of the high-frequency signal gold finger 331, to form the hollowed-out area 301. The first insulating support layer 361 and the second insulating support layer 362 within the projection area on one side of the high-frequency signal gold finger 331 are hollowed out to form the first groove 302; and the second insulating support layer 362 within the projection area of the high-frequency signal gold finger 331 is hollowed out to form the second groove 304.

In some embodiments, the metal intermediate layer assembly 305 further includes at least one metal intermediate layer, where the at least one metal intermediate layer within the projection area of the high-frequency signal gold finger 331 and within the projection area on one side of the high-frequency signal gold finger 331, starting from the first layer from top to bottom in sequence, has at least one layer without a metal layer, to form the hollowed-out area 301, that is, within the projection area of the high-frequency signal gold finger 331 and within the projection area on one side of the high-frequency signal gold finger 331, the metal layer is absent between the high-frequency signal gold finger 331 and the metal layer at the bottom surface of the first groove 302, to form the hollowed-out area 301; and all the insulating support layers above the first metal layer within the projection area on one side of the high-frequency signal gold finger 331 are hollowed out to form the first groove 302, that is, the first groove 302 is respectively provided on both sides of the high-frequency signal gold finger 331, and the metal layer at the bottom surface of the first groove 302 is the first metal layer; and all the insulating support layers above the first metal layer within the projection area of the high-frequency signal gold finger 331, except for the first insulating support layer 361, are hollowed out to form the second groove 304.

For example, the metal intermediate layer assembly 305 further includes a second metal intermediate layer 352, where the metal layer is absent from the first metal intermediate layer 351 and the second metal intermediate layer 352 within the projection area of the high-frequency signal gold finger 331 and within the projection area on one side of the high-frequency signal gold finger 331, to form the hollowed-out area 301. The first insulating support layer 361, the second insulating support layer 362, and the third insulating support layer 363 within the projection area on one side of the high-frequency signal gold finger 331 are hollowed out to form the first groove 302. The second insulating support layer 362 and the third insulating support layer 363 within the projection area of the high-frequency signal gold finger 331 are hollowed out to form the second groove 304.

For example, the metal intermediate layer assembly further includes a third metal intermediate layer 353, a fourth metal intermediate layer 354, and a fifth metal intermediate layer 355, where the metal layer is absent from the first metal intermediate layer 351, the second metal intermediate layer 352, the third metal intermediate layer 353, and the fourth metal intermediate layer 354 within the projection area of the high-frequency signal gold finger 331 and within the projection area on one side of the high-frequency signal gold finger 331, to form the hollowed-out area 301. However, the metal layer is present in the fifth metal intermediate layer 355 within the projection area of the high-frequency signal gold finger 331 and the projection area on one side of the high-frequency signal gold finger 331; the first insulating support layer 361, the second insulating support layer 362, the third insulating support layer 363, a fourth insulating support layer 364, and a fifth insulating support layer 365 within the projection area on one side of the high-frequency signal gold finger 331 are hollowed out to form the first groove 302, that is, the bottom surface of the first groove 302 is the fifth metal intermediate layer 355. The second insulating support layer 362, the third insulating support layer 363, the fourth insulating support layer 364, and the fifth insulating support layer 365 within the projection area of the high-frequency signal gold finger 331 are hollowed out to form the second groove 304.

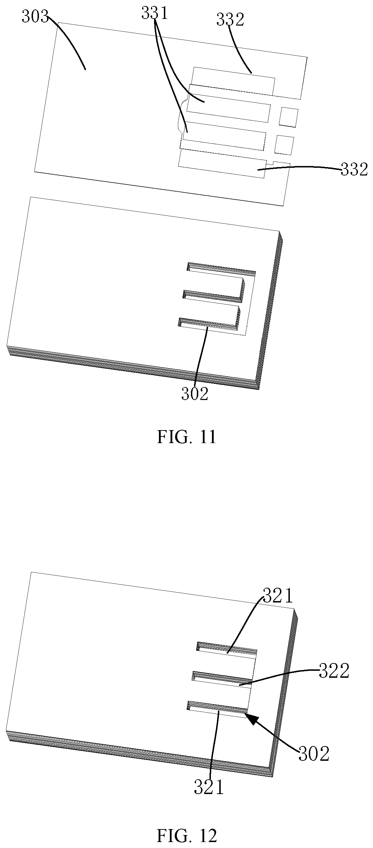

FIG. 10 is a structural diagram of a circuit board provided according to some embodiments. FIG. 11 is an exploded view of a circuit board provided according to some embodiments. FIG. 12 is a structural diagram of a circuit board where a first metal surface layer is removed provided according to some embodiments. As shown in FIG. 10 and FIG. 11, in some embodiments, both ends of the first groove 302 are flush with both ends of the projection area of the first spring contact 181 on the high-frequency signal gold finger 331, such that a length of the first groove 302 is equal to a projection length of the first spring contact 181 on the high-frequency signal gold finger 331. The length of the first groove 302 is equal to the projection length of the first spring contact 181 on the high-frequency signal gold finger 331, increasing the impedance of the area from the contact of the high-frequency signal gold finger 331 with the first spring contact 181 to a tail end of the high-frequency signal gold finger 331, and mitigating the impedance discontinuity of the high-frequency signal gold finger 331 caused by connection between the first spring contact 181 and the high-frequency signal gold finger 331, which ensures the continuity of the impedance of the high-frequency signal gold finger and the transmission quality of the high-frequency signal.

Either one side or both sides of the high-frequency signal gold finger 331 may be hollowed out to form the first groove 302. The first groove 302 includes at least one recessed portion, and the great width of the recessed portion indicates the high proportion of air in the dielectric between the high-frequency signal gold finger 331 and the reference ground, and the great impedance of the area from the contact of the high-frequency signal gold finger 331 with the first spring contact 181 to the tail end of the high-frequency signal gold finger 331. To increase the impedance of the area from the contact of the high-frequency signal gold finger 331 with the first spring contact 181 to the tail end of the high-frequency signal gold finger 331, in some embodiments, a width of the recessed portion is equal to a width of a gap between gold fingers on both sides of the recessed portion.

For example, the first groove 302 includes a first recessed portion 321, where the first recessed portion 321 is located between the high-frequency signal gold finger 331 and the ground gold finger 332, and a width of the first recessed portion 321 is equal to a width of a gap between the high-frequency signal gold finger 331 and the ground gold finger 332.

For example, the first groove 302 includes a second recessed portion 322, where the second recessed portion 322 is located between two adjacent high-frequency signal gold fingers 331, and a width of the second recessed portion 322 is equal to a width of a gap between the two adjacent high-frequency signal gold fingers 331.

For example, the first groove 302 includes the first recessed portion 321 and the second recessed portion 322, where the width of the first recessed portion 321 is equal to the width of the gap between the high-frequency signal gold finger 331 and the ground gold finger 332, and the width of the second recessed portion 322 is equal to the width of the gap between the two adjacent high-frequency signal gold fingers 331.

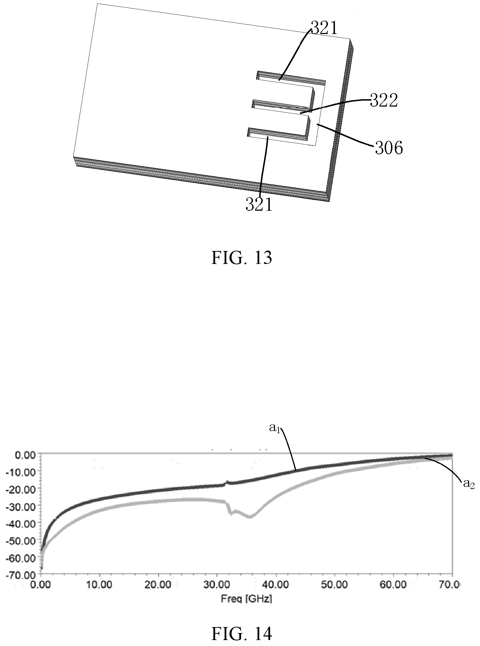

FIG. 13 is a structural diagram of another circuit board where a first metal surface layer is removed provided according to some embodiments. Since electric field lines of the high-frequency signal gold finger 331 diverge outward, in order to further increase the impedance of the high-frequency signal gold finger 331, as shown in FIG. 13, in some embodiments, the first insulating support layer in the projection area between the high-frequency signal gold finger 331 and the edge of the circuit board 300 is hollowed out to form a third groove 306, where the third groove 306 is located in the projection area of the first spring contact 181 on the circuit board 300. The proportion of air in the dielectric between the high-frequency signal gold finger 331 and the reference ground increases, and the impedance of the area between the contact of the high-frequency signal gold finger 331 with d the first spring contact 181 and the tail end of the high-frequency signal gold finger 331 increases, thereby mitigating the impedance discontinuity of the high-frequency signal gold finger 331 caused by connection between the first spring contact 181 and the high-frequency signal gold finger 331.

In some embodiments, all the insulating support layers above the first metal layer in the projection area between the high-frequency signal gold finger 331 and the edge of the circuit board 300 are hollowed out to form the third groove 306, that is, the third groove 306 is provided between the high-frequency signal gold finger 331 and the edge of the circuit board 300, where the bottom surface of the third groove 306 is the metal layer, and the metal layer at the bottom surface of the third groove 306 and the first metal layer within the projection area on one side of the high-frequency signal gold finger 331 are located on the same layer of the circuit board 300.

In some embodiments, the third groove 306 extends outward such that the third groove 306 is communicated with the first groove 302, increasing the proportion of air in the dielectric between the high-frequency signal gold finger 331 and the reference ground, and increasing the impedance of the area between the contact of the high-frequency signal gold finger 331 with the first spring contact 181 and the tail end of the high-frequency signal gold finger 331. For example, the first groove 302 includes the first recessed portion 321, where the third groove 306 is communicated with the first recessed portion 321; the first groove 302 includes the third groove 306, where the third groove 306 is communicated with the second recessed portion 322; the first groove 302 includes the first recessed portion 321 and the second recessed portion 322, where the third groove 306 is communicated with the first recessed portion 321 and the second recessed portion 322, respectively.

The third groove 306 is located at the tail end of the high-frequency signal gold finger 331, away from a head end of the high-frequency signal gold finger 331, that is, the third groove 306 is away from the projection area of the spring contact 108 on the circuit board 300. This not only increases the impedance of the area between the contact of the high-frequency signal gold finger 331 with the first spring contact 181 and the head end of the high-frequency signal gold finger 331, but also increases the impedance of the area between the contact of the high-frequency signal gold finger 331 with the first spring contact 181 and the tail end of the high-frequency signal gold finger 331, resulting in impedance mismatch at the contact of the high-frequency signal gold finger 331. In order to avoid this problem, in some embodiments, the third groove 306 is located in the projection area of the spring contact 108 on the circuit board 300. The third groove 306 is located in the projection area of the spring contact 108 on the circuit board 300, which only increases the impedance of the area between the contact of the high-frequency signal gold finger 331 with the first spring contact 181 and the tail end of the high-frequency signal gold finger 331, and improves the impedance matching at the contact of the high-frequency signal gold finger 331.

The above describes the circuit board from the perspective of its formation, and the following describes the circuit board from the perspective of its final form. To solve the problem of the impedance discontinuity of the high-frequency signal gold finger 331, the first groove 302 is provided in one side of the high-frequency signal gold finger 331, where the bottom surface of the first groove 302 is the metal layer; the metal layer at the bottom surface of the first groove 302 is located between the first metal surface layer and the second metal surface layer; within the projection area of the high-frequency signal gold finger 331, the metal layer is absent between the high-frequency signal gold finger 331 and the metal layer at the bottom surface of the first groove 302; and the high-frequency signal gold finger 331 is provided on the surface of the first insulating support layer.

As shown in FIG. 8, within the projection area of the high-frequency signal gold finger 331, at least one insulating support layer is provided between the first insulating support layer 361 and the metal layer at the bottom surface of the first groove 302.

As shown in FIG. 9, within the projection area of the high-frequency signal gold finger 331, the insulating support layer is absent between the first insulating support layer 361 and the metal layer at the bottom surface of the first groove 302, and only a gap is present to form the second groove 304.

As shown in FIG. 12, the third groove 306 is provided between the high-frequency signal gold finger 331 and the edge of the circuit board 300, where the bottom surface of the third groove 306 is the metal layer.

FIG. 14 is a schematic diagram of simulated reflection loss results of high-frequency signal gold fingers provided according to some embodiments. As shown in FIG. 14, an abscissa represents frequency and an ordinate represents a first decibel, where the first decibel is a ratio of power of a reflected signal at a first port to power of an incident signal at the first port; a1 represents a simulated reflection loss result of the high-frequency signal gold finger after optimization; and a2 represents a simulated reflection loss result of the high-frequency signal gold finger before optimization. The reflection loss of the high-frequency signal gold finger after optimization is greater than the reflection loss of the high-frequency signal gold finger before optimization.

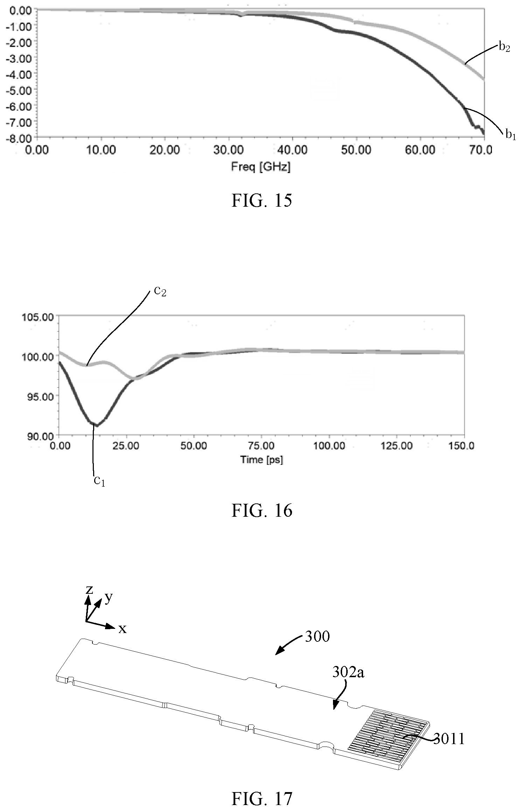

FIG. 15 is a schematic diagram of simulated loss results of high-frequency signal gold fingers provided according to some embodiments. As shown in FIG. 15, an abscissa represents frequency and an ordinate represents a second decibel, where the second decibel is a ratio of power of an emergent signal at a second port to power of the incident signal at the first port; b1 represents a simulated loss result of the high-frequency signal gold finger after optimization, and b2 represents a simulated reflection loss result of the high-frequency signal gold finger before optimization. The loss of the high-frequency signal gold finger after optimization is less than the loss of the high-frequency signal gold finger before optimization.

FIG. 16 is a structural schematic diagram of TDR simulation of high-frequency signal gold fingers provided according to some embodiments. As shown in FIG. 16, an abscissa represents time and an ordinate represents impedance; c1 represents a TDR simulation result of the high-frequency signal gold finger after optimization, and c2 represents a TDR loss simulation result of the high-frequency signal gold finger before optimization. The impedance of the high-frequency signal gold finger after optimization is greater than the impedance of the high-frequency signal gold finger before optimization, and is closer to 100Ω.

In some embodiments, the optical module includes a circuit board. The circuit board includes a first metal surface layer, a second metal surface layer, and a first metal intermediate layer, where the first metal intermediate layer is a first metal layer below the first metal surface layer, the first metal surface layer is located on an upper surface of the circuit board, the second metal surface layer is located on a lower surface of the circuit board, the upper surface and lower surface of the circuit board are arranged opposite to each other, the first metal intermediate layer is located between the first metal surface layer and the second metal surface layer, the first metal intermediate layer is located below the first metal surface layer, and a first insulating support layer is provided between the first metal intermediate layer and the first metal surface layer. Gold fingers are provided on the first metal surface layer, surfaces of the gold fingers are configured to connect to spring contacts to implement electrical connection; and the gold fingers include high-frequency signal gold fingers. A metal layer is absent from the first metal intermediate layer within a projection area of the high-frequency signal gold fingers, to form a hollowed-out area. The hollowed-out area is provided, such that the metal layer moves downward, increasing the dielectric thickness between the high-frequency signal gold finger and the reference ground, and then increasing the impedance of the high-frequency signal gold finger. A gap is provided on one side of the gold finger to expose the first insulating support layer between two adjacent gold fingers. A first insulating support layer within the projection area on one side of the high-frequency signal gold fingers is hollowed out to form a first groove. The first groove is provided, such that the proportion of air in the dielectric between the high-frequency signal gold finger and the reference ground increases, reducing the dielectric constant of the dielectric between the high-frequency signal gold finger and the reference ground, and then increasing the impedance of the high-frequency signal gold finger. In some embodiments, the hollowed-out area increases the dielectric thickness between the high-frequency signal gold finger and the reference ground, increasing the impedance of the high-frequency signal gold finger to mitigate the impedance discontinuity of the high-frequency signal gold finger caused by connection between the spring contact and the high-frequency signal gold finger; the first groove reduces the dielectric constant of the dielectric between the high-frequency signal gold finger and the reference ground, further increasing the impedance of the high-frequency signal gold finger, and further mitigating the impedance discontinuity of the high-frequency signal gold finger caused by connection between the spring contact and the high-frequency signal gold finger, thereby ensuring the impedance continuity of the high-frequency signal gold finger and the transmission quality of high-frequency signals.

Generally, to ensure the standardization and aesthetics of the gold finger design, the gold fingers are typically centered at one end edge of the circuit board, and the gold fingers on both upper and lower sides thereof are aligned. Correspondingly, a matching socket of the cage of the host computer is also designed accordingly, for example, metal spring contacts of the cage of the host computer that are electrically connected to the gold fingers are aligned vertically. This is conducive to the design of the gold fingers and the manufacturing and processing of the circuit board. However, in practical applications, the circuit board is usually relatively thin, generally around 1mm, which results in the metal spring contacts inside the socket of the host computer being close to each other. When the optical module is removed from the host computer, the metal spring contacts may accidentally contact each other. In some examples, when the optical module is hot-swapped while powered, an electrical device is prone to short-circuit hazards.

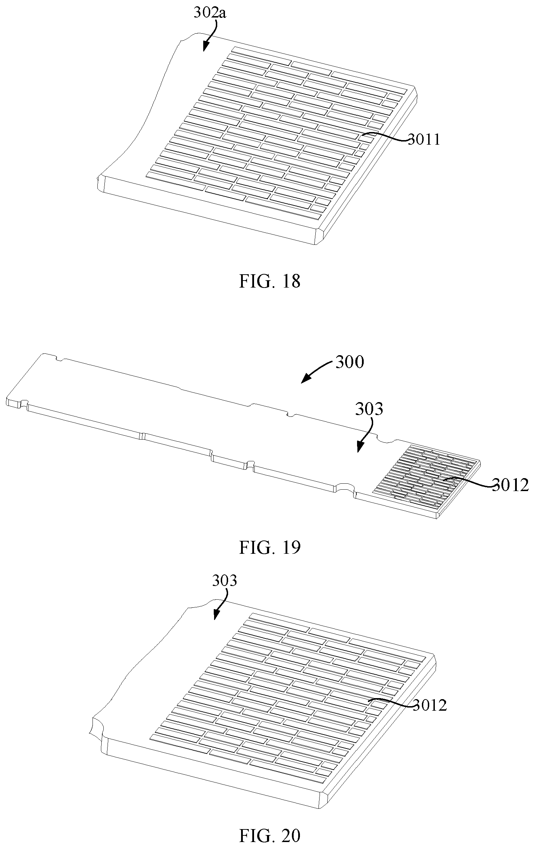

FIG. 17 is a first structural schematic diagram of a circuit board in an optical module provided according to an embodiment of the present disclosure; FIG. 18 is an enlarged view of a first row of gold fingers in an optical module provided according to an embodiment of the present disclosure; FIG. 19 is a second structural schematic diagram of a circuit board in an optical module provided according to an embodiment of the present disclosure; and FIG. 20 is an enlarged view of a second row of gold fingers in an optical module provided according to an embodiment of the present disclosure. FIG. 19 shows a viewing angle after a viewing angle in FIG. 17 is turned by 180°. Referring to FIG. 17- FIG. 20, the circuit board 300 has a first surface 302a and a second surface 303. In some examples of the present disclosure, the first surface 302a and the second surface 303 may be two opposite surfaces of the circuit board 300. A direction shown in FIG. 17 is taken as an example for illustration, the first surface 302a may be the upper surface of the circuit board 300 in FIG. 17, and the second surface may be the lower surface of the circuit board 300 in FIG. 17. Of course, in some examples, when the viewing angle shown in FIG. 19 is taken as an example, the first surface may be the lower surface in FIG. 19, and the second surface 303 may be the upper surface in FIG. 19.

In some examples of the present disclosure, the gold fingers 301a may include: a first row of gold fingers 3011 and a second row of gold fingers 3012. The first row of gold fingers 3011 may be provided on the first surface 302a, and the first row of gold fingers 3011 may be arranged along the width direction of the circuit board 300 (for example, a direction indicated by the y-axis in FIG. 17). In some examples of the present disclosure, the first row of gold fingers 3011 is configured to be electrically connected to the first row of metal spring contacts on a first side wall of the host computer. In some examples, the first side wall of the host computer may be a side wall opposite to the first surface 302a of the circuit board 300. It can be understood that, in some examples of the present disclosure, the second row of gold fingers 3012 may be provided on the second surface 303, and the second row of gold fingers 3012 may also be arranged along the width direction of the circuit board 300. The second row of gold fingers 3012 is configured to be electrically connected to second metal spring contacts on a second side wall of the host computer. In some examples, the second side wall of the host computer may be a side wall opposite to the second surface 303 of the circuit board 300; that is, in some embodiments of the present disclosure, after the optical module is electrically connected to the host computer, the circuit board is located between the first row of metal spring contacts and the second row of metal spring contacts.

In some examples of the present disclosure, surfaces of the first row of gold fingers and surfaces of the second row of gold fingers have a height difference. For example, when the first row of gold fingers and the second row of gold fingers are formed on the first surface and second surface of the circuit board, due to certain processing errors in the manufacturing process, there may be unevenness between the surfaces of the first row of gold fingers and the surfaces of the second row of gold fingers, resulting in a height difference between the surfaces of the first row of gold fingers and the surfaces of the second row of gold fingers. When the circuit board is removed from between the first row of metal spring contacts and the second row of metal spring contacts, there is friction between the surfaces of the first row of gold fingers and the first row of metal spring contacts, and friction between the surfaces of the second row of gold fingers and the second row of metal spring contacts, such that the first row of gold fingers possibly lifts up the first row of metal spring contacts and shifts toward the direction of the second row of metal spring contacts, and the second row of gold fingers possibly lifts up the second row of metal spring contacts and shifts toward the direction of the first row of metal spring contacts, which may easily lead to accidental contact between the first row of metal spring contacts and the second row of metal spring contacts.

In addition, to ensure the stability of the electrical connection between the circuit board and the host computer, a spacing between the first row of metal spring contacts and the second row of metal spring contacts is usually less than the thickness of the circuit board, such that after the circuit board is inserted between the first row of metal spring contacts and the second row of metal spring contacts, the first row of metal spring contacts and the second row of metal spring contacts form an interference clamping on the circuit board. Generally, the circuit board is relatively thin, generally around 1mm; thus, after the circuit board is removed from between the first row of metal spring contacts and the second row of metal spring contacts, the first row of metal spring contacts and the second row of metal spring contacts that are closely spaced may also accidentally contact each other.

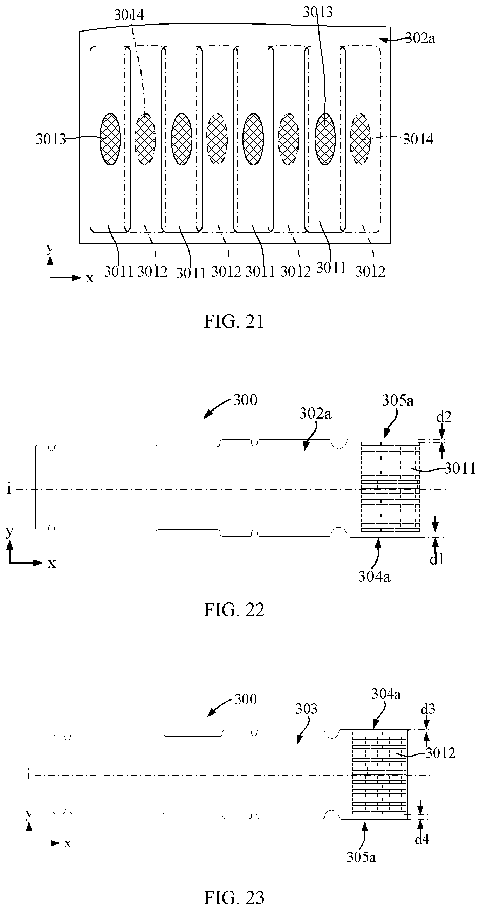

FIG. 21 is a perspective structural diagram of gold fingers in an optical module provided according to an embodiment of the present disclosure. Referring to FIG. 21, in some examples of the present disclosure, the first gold finger in the first row of gold fingers 3011 has a first contact 3013, and the first contact 3013 is configured to contact the first spring contact in the first row of metal spring contacts. In some embodiments of the present disclosure, the first gold finger may be any gold finger in the first row of gold fingers 3011. In some examples, the first gold finger may also be the gold finger in the first row of gold fingers 3011 that is electrically connected to the first spring contact.

In other words, the first row of gold fingers 3011 has multiple first gold fingers along an arrangement direction. It can be understood that, in some examples, some of the multiple first gold fingers may be data signal gold fingers, for example, high-speed gold fingers for transmitting high-speed data signals, or low-speed gold fingers for transmitting low-speed data signals; and other some of the multiple first gold fingers may be power gold fingers, for example, they can provide electric energy to various electrical components on the circuit board. The arrangement of the multiple gold fingers along the width of the circuit board may be configured according to relevant protocols. This is not limited in the present disclosure.

It can be understood that the first contact 3013 may be the point or area where the first gold finger contacts the first spring contact. For ease of understanding, referring to FIG. 9, in some embodiments of the present disclosure, the first contact 3013 is represented by an elliptical dot. It should be noted that the shape of the first contact 3013 may also be other shapes. In the embodiments of the present disclosure, the elliptical dot is shown only as a specific example and does not limit the shape of the first contact.

In some examples of the embodiments of the present disclosure, the second gold finger in the second row of gold fingers 3012 has a second contact 3014, and the second contact 3014 is configured to contact the second spring contact of the second row of metal spring contacts. It can be understood that the arrangement of the second contact 3014 may be the same as or similar to the arrangement of the first contact 3013 in the foregoing embodiments of the present disclosure. For details, reference may be made to the detailed description of the foregoing embodiments of the present disclosure. This will not be repeated herein.

In some embodiments of the present disclosure, the first contact and the second contact are staggered.

In some examples, the first gold finger in the first row of gold fingers 3011 may be translated by a preset distance relative to the second gold finger in the second row of gold fingers 3012; for example, referring to FIG. 9, the first gold finger in the first row of gold fingers 3011 may be translated along a direction indicated by a positive direction of the x-axis in FIG. 21, such that the first contact and the second contact are staggered. It can be understood that, in some examples, in order to increase the density of the gold fingers, after the first row of gold fingers 3011 is translated, the first gold finger and the second gold finger may also have a partially overlapping area, thereby reducing the gap between adjacent gold fingers and increasing the density of gold fingers.

It can be understood that, in other examples, the second gold finger in the second row of gold fingers 3012 may also be translated by a preset distance relative to the first row of gold fingers 3011, such that the first contact and the second contact are staggered.

The first contact and the second contact are staggered, that is, after the first gold finger in the first row of gold fingers 3011 is translated by a preset distance relative to the second gold finger in the second row of gold fingers 3012, the first contact 3013 and the second contact 3014 do not overlap. Thus, the first spring contact on a first side wall of the socket and the second spring contact on a second side wall thereof can be completely staggered, thereby avoiding accidental contact between the first spring contact and the second spring contact after the circuit board is removed from between the first spring contact and the second spring contact, and improving the safety of use of the optical module.

Referring to FIG. 21, in some examples of the present disclosure, the first gold finger in the first row of gold fingers and the second gold finger in the second row of gold fingers are staggered along the width direction of the circuit board, such that the first contact and the second contact are staggered along the arrangement direction of the first row of gold fingers 3011.

In some embodiments of the present disclosure, the arrangement direction of the first row of gold fingers 3011 and the arrangement direction of the second row of gold fingers 3012 may be the same, similar, or consistent. For example, the arrangement direction of the first row of gold fingers 3011 and the arrangement direction of the second row of gold fingers 3012 may both be along the width direction of the circuit board 300. FIG. 21 is taken as an example for illustration, the first row of gold fingers 3011 and the second row of gold fingers 3012 may be arranged along a direction indicated by the x-axis in FIG. 21.

In some examples of the present disclosure, the first contacts are located within a gap between the two adjacent second contacts. In other words, the first contacts are within the gap between the two adjacent second contacts, and correspondingly, the second contacts are within the gap between the two adjacent first contacts.

In some examples of the present disclosure, the first contact is located outside the second contact corresponding to an outermost second gold finger in the second row of gold fingers 3012. For example, referring to FIG. 21, a leftmost first contact in FIG. 21 is located to the left of a leftmost second contact.

In other words, in some optional examples of the present disclosure, referring to FIG. 21, along the width direction of the circuit board (for example, the direction indicated by the x-axis in FIG. 21), the first contact 3013 and the second contact 3014 are staggered, and along the length direction of the circuit board (for example, a direction indicated by the y-axis in FIG. 21), the first contact and the second contact may be not staggered.

FIG. 22 is a structural diagram of the first row of gold fingers on the first surface in the optical module provided according to embodiments of the present disclosure. Referring to FIG. 22, in some examples of the present disclosure, when the first row of gold fingers 3011 on the first surface 302a is designed, the first row of gold fingers 3011 may be integrally translated by a preset distance along the width direction of the circuit board 300, such that the first contact and the second contact on the second row of gold fingers are staggered.

In some examples, along the width direction of the circuit board 300, the circuit board 300 has a first side surface 304a and a second side surface 305; along the arrangement direction of the first row of gold fingers 3011, a first gold finger in the first row of gold fingers 3011 facing the first side surface 304a has a first distance d1 from the first side surface 304a, and a first gold finger in the first row of gold fingers 3011 facing the second side surface 305a has a second distance d2 from the second side; and the first distance d1 is greater than the second distance d2. In other words, the first row of gold fingers 3011 may be integrally shifted by a preset distance toward the direction of the second side surface 305a.

In some examples of the embodiments of the present disclosure, an overall width of the circuit board 300 may be 16.34mm-16.50mm, where the first distance d1 may be 1.15mm-1.31mm, and the second distance d2 may be 0.73mm-0.89mm. In some optional examples, referring to FIG. 22, a distance between the first gold finger in the first row of gold fingers 3011 facing the first side surface 304a and the central axis i of the circuit board 300 is 7.0mm, and a distance between the first gold finger in the first row of gold fingers 3011 facing the second side surface 305a and the central axis i of the circuit board 300 may be 7.4mm; that is, in a specific example, the first row of gold fingers 3011 may be translated 0.4mm toward the second side surface 305a along the width direction of the circuit board 300.

FIG. 23 is a structural diagram of a second row of gold fingers on a second surface in an optical module provided according to an embodiment of the present disclosure. In some examples of the embodiments of the present disclosure, when the second row of gold fingers 3012 on the second surface 303 is designed, the second row of gold fingers 3012 may be designed as normal symmetry. Thus, since the first row of gold fingers is designed to be translated by a preset distance, the first contact and the second contact are staggered. Of course, in other examples, referring to FIG. 23, the second row of gold fingers 3012 may also be integrally translated by a preset distance along the width direction of the circuit board 300. The translation direction of the second row of gold fingers 3012 along the width direction of the circuit board 300 may be opposite to the translation direction of the first row of gold fingers.

In some examples, along an arrangement direction of the second row of gold fingers 3012, a second gold finger in the second row of gold fingers 3012 facing the first side surface 304a has a third distance d3 from the first side surface 304a, and a second gold finger in the second row of gold fingers 3012 facing the second side surface 305a has a fourth distance d4 from the second side surface 305a; and the fourth distance d4 is greater than the third distance d3. In other words, in some examples of the embodiments of the present disclosure, the second row of gold fingers 3012 may be integrally translated by a preset distance toward the first side surface 304a, such that the second contact and the first contact are completely staggered, that is, the first contacts are located within the gap between the two adjacent second contacts, and correspondingly, the second contacts are located within the gap between the two adjacent first contacts.

It can be understood that, in some embodiments of the present disclosure, the translation distance of the second row of gold fingers 3012 toward the first side surface 304a may be the same as or close to the translation distance of the first row of gold fingers toward the second side surface 305a. Thus, the first contact and the second contact are completely staggered, such that accidental contact between the first spring contact and the second spring contact is avoided, improving the safety of hot swapping of the optical module.

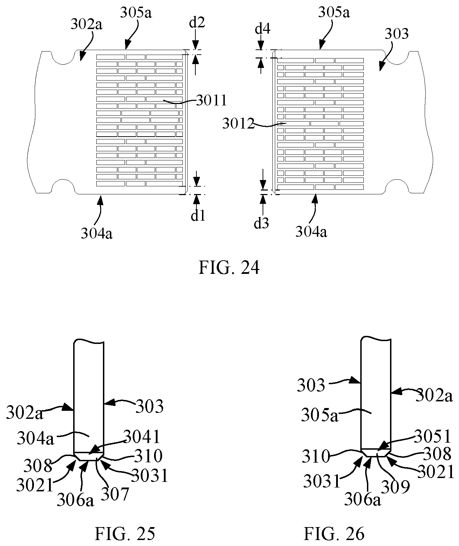

FIG. 24 is a comparative structural diagram of a first row of gold fingers and a second row of gold fingers in an optical module provided according to an embodiment of the present disclosure. Referring to FIG. 24, in some examples of the embodiments of the present disclosure, the first distance d1 is greater than the third distance d3, and the fourth distance d4 is greater than the second distance d2. The first distance d1 and the second distance d2 have a first difference value, and the fourth distance d4 and the third distance d3 have a second difference value.

In some examples of the embodiments of the present disclosure, the first difference value may be 0.4mm, that is, the first row of gold fingers 3011 is integrally translated 0.4mm toward the second side surface 305a. It can be understood that, in other examples, the second difference value may also be 0.4mm, that is, the second row of gold fingers 3012 is integrally translated 0.4mm toward the first side surface 304a. Thus, a staggered distance between the first contact and the second contact along the arrangement direction of the first row of gold fingers 3011 is 0.8mm, that is, a staggered distance between the first row of gold fingers 3011 and the second row of gold fingers 3012 is a sum of the first difference value and the second difference value.

It should be noted that the numerical values and ranges involved in the embodiments of the present utility model are approximate values and may have a certain range of errors due to manufacturing processes. These errors can be deemed negligible by those skilled in the art.

In some embodiments of the present disclosure, the first row of gold fingers 3011 and the second row of gold fingers 3012 are respectively translated, such that the first contact and the second contact are staggered along the arrangement direction of the first row of gold fingers 3011. Thus, the first row of gold fingers 3011 and the second row of gold fingers 3012 are translated only by a short distance to implement misalignment between the first contact and the second contact, which can reduce the space occupied by the first row of gold fingers 3011 and the second row of gold fingers 3012, and reduce the size of the circuit board.

In other examples of the embodiments of the present disclosure, a width of the first gold finger in the first row of gold fingers 3011 may be the same as or similar to a width of the second gold finger in the second row of gold fingers 3012, and a first gap is present between the two adjacent first gold fingers in the first row of gold fingers 3011, and a second gap is present between the two adjacent second gold fingers in the second row of gold fingers 3012, where the width of the first gold finger is greater than the width of the second gap, and the width of the second gold finger is greater than the width of the first gap.

In some examples, a sum of the width of the first gold finger and the width of the first gap may be 0.8mm; or in other examples, a sum of the width of the second gold finger and the width of the second gap may be 0.8mm. This facilitates designing the gold fingers, and the first contacts and the second contacts on the gold fingers, which can increase the density of the gold fingers and improve the transmission efficiency of high-speed signals in the optical module.

FIG. 25 is a first lateral view of a front end of a circuit board in an optical module provided according to an embodiment of the present disclosure, and FIG. 26 is a second lateral view of a front end of a circuit board in an optical module provided according to an embodiment of the present disclosure. FIG. 25 is a lateral view observed from a first side surface 304a, and FIG. 26 is a lateral view observed from a second side surface 305a. Referring to FIG. 25 and FIG. 26, a front end of the circuit board is tapered, and the circuit board further has a first inclined surface 307, a second inclined surface 308, a third inclined surface 309, and a fourth inclined surface 310. The first inclined surface 307 is connected between the first side surface 304a and a front end surface 306a of the circuit board, that is, the first inclined surface 307 may be an inclined surface formed at an angle between the first side surface 304a and the front end surface 306a; and in some examples, the angle between the first side surface 304a and the front end surface 306a may be subjected to chamfering treatment.

The second inclined surface 308 is connected between the first surface 302a and the front end surface 306a, that is, the second inclined surface 308 may be formed between the first surface 302a and the front end surface 306a; and in some examples, an angle between the first surface 302a and the front end surface 306a may be subjected to chamfering treatment. In some examples of the embodiments of the present disclosure, the first row of gold fingers may be located at a rear end of the second inclined surface, that is, the first row of gold fingers is provided on the first surface 302a.

The third inclined surface 309 is connected between the second side surface 305a and the front end surface 306a, where a formation method of the third inclined surface 309 may be the same as or similar to that of the first inclined surface 307. This will not be repeated herein.

The fourth inclined surface 310 is connected between the second surface 303 and the front end surface 306a, where a formation method of the fourth inclined surface 310 may be the same as or similar to that of the second inclined surface 308. This will not be repeated herein. In some examples of the embodiments of the present disclosure, the second row of gold fingers may be located at a rear end of the fourth inclined surface 310, that is, the second row of gold fingers is provided on the second surface 303.

In some examples, the first side surface 304a and the front end surface 306a form a first chamfer 3041 at the first inclined surface 307, that is, the chamfering treatment in the embodiments of the present disclosure, where the size of the first chamfer 3041 along the width direction of the circuit board is 0.25mm-0.45mm, and an inclination angle of the first inclined surface 307 relative to the first side surface 304a may be 45°.

In other examples, the second side surface 305a and the front end surface 306a form a second chamfer 3051 at the third inclined surface 309. As a specific example, the second chamfer 3051 may be symmetrical to the first chamfer 3041.

In other examples of the embodiments of the present disclosure, the first surface 302a and the front end surface 306a form a third chamfer 3021 at the second inclined surface 308, and the size of the third chamfer 3021 along the length direction of the circuit board is 0.15mm-0.35mm, where the inclination angle of the second inclined surface 308 relative to the first surface 302a may also be 45°.

In other examples, the second surface 303 and the front end surface 306a form a fourth chamfer 3031 at the fourth inclined surface 310. As a specific example, the fourth chamfer 3031 is symmetrical to the third chamfer 3021.

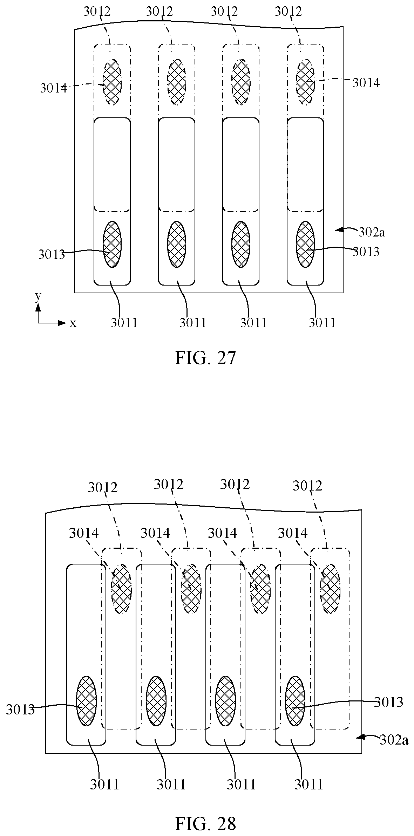

FIG. 27 is another perspective structural diagram of gold fingers in an optical module provided according to an embodiment of the present disclosure. In other examples of the embodiments of the present disclosure, referring to FIG. 27, the first contact and the second contact are staggered along an extension direction of the gold finger 301a. Along the extension direction of the gold finger, the first contact is located on one side of the second contact.

In some examples of the embodiments of the present disclosure, the extension direction of the gold finger may be the length direction of the circuit board (for example, a direction indicated by the y-axis in FIG. 27). In other words, in some examples of the embodiments of the present disclosure, the first row of gold fingers 3011 and the second row of gold fingers 3012 may also be staggered along the length direction of the circuit board, or the first contact 3013 and the second contact 3014 may be staggered.

As an optional example, referring to FIG. 27, the first row of gold fingers 3011 may be integrally shifted by a preset distance toward the front end surface along the length direction of the circuit board. In other examples, the first row of gold fingers 3011 may be integrally shifted by a preset distance toward the front end surface along the length direction of the circuit board, and the second row of gold fingers 3012 may be integrally shifted by a preset distance toward one side away from the front end surface along the length direction of the circuit board, such that the first contact and the second contact are staggered in the length direction of the circuit board. In other words, the first contact may be located on one side of the second contact facing the front end surface.

It can be understood that, in other examples, the first row of gold fingers 3011 may be integrally shifted by a preset distance away from the front end surface along the length direction of the circuit board, while the second row of gold fingers 3012 may be integrally shifted by a preset distance toward the front end surface along the length direction of the circuit board, such that the first contact and the second contact are staggered. In other words, the first contact may be located on one side of the second contact away from the front end surface. Thus, the first contact and the second contact are staggered in the extension direction of the gold finger 301. This can reduce the space required in the arrangement direction of the gold fingers, thereby increasing the number of gold fingers 301 that can be arranged or reducing the width of the circuit board, and improving the density of gold finger arrangement.

FIG. 28 is yet another perspective structural diagram of gold fingers in an optical module provided according to an embodiment of the present disclosure. Referring to FIG. 28, in other optional examples of the embodiments of the present disclosure, the first contact and the second contact are staggered along the arrangement direction of the first row of gold fingers 3011; the first contact is located within the gap between the two adjacent second contacts; or the first contact is located outside the second contact corresponding to an outermost second gold finger in the second row of gold fingers 3012; the first contact and the second contact are also staggered along the extension direction of the gold finger; and the first contact is located on one side of the second contact along the extension direction of the gold finger.

In other words, in other examples of the embodiments of the present disclosure, the first contact and the second contact may be staggered in both directions, that is, in the arrangement direction of the gold fingers, for example, the first contact and the second contact are staggered in the width direction of the circuit board. Additionally, the first contact and the second contact may also be staggered in the extension direction of the gold fingers. It can be understood that staggering in the arrangement direction of the gold fingers may be performed with reference to detailed descriptions in the foregoing embodiments of the present disclosure. This will not be repeated herein. Additionally, staggering in the extension direction of the gold fingers may also be performed with reference to detailed description in the foregoing embodiments of the present disclosure. This will not be repeated herein.

For the optical module provided according to the embodiments of the present disclosure, the gold fingers are formed at one end of the circuit board, the circuit board is provided within the cavity formed by covering the upper shell and the lower shell, and the gold fingers extend out of an electrical port at one end of the cavity, thereby facilitating electrical connection between the circuit board and the host computer for transmitting electrical signals. The first row of gold fingers is provided on the first surface of the circuit board, arranged along the width direction of the circuit board, and electrically connected to a first row of metal spring contacts on the first side wall of the host computer for transmitting the electrical signals. The second row of gold fingers is provided on the second surface of the circuit board, arranged along the width direction of the circuit board, and electrically connected to a second row of spring contacts on the second side wall of the host computer for transmitting the electrical signals. The first surface and the second surface are two opposite surfaces of the circuit board, and the first side wall and the second side wall are two opposite side walls of the host computer. Surfaces of the first row of gold fingers and the second row of gold fingers have a height difference, and a distance between the first row of metal spring contacts and the second row of metal spring contacts is less than the thickness of the circuit board. Thus, the gold fingers can be formed on both opposite surfaces of the circuit board, increasing the number of gold fingers, ensuring signal transmission rate, and enabling high-speed signal transmission. Additionally, in the embodiments of the present disclosure, the first gold finger in the first row of gold fingers has a first contact, and the first contact is configured to contact the first spring contact in the first row of metal spring contacts; the second gold finger in the second row of gold fingers has a second contact; and the second contact is configured to contact the second spring contact in the second row of metal spring contacts. In the embodiments of the present disclosure, the first contacts and the second contacts are arranged in a staggered manner, such that the first spring contacts and the second spring contacts are also staggered. Thus, when the optical module is inserted into the host computer, the first spring contact of the cage of the host computer contacts the first gold finger at the first contact, and the second spring contact of the host computer contacts the second gold finger at the second contact. In the embodiments of the present disclosure, the first contacts and the second contacts are arranged in a staggered manner, such that the first spring contacts and second spring contacts of the cage of the host computer are staggered. When the circuit board is removed from between the first spring contact and the second spring contact, and either the first spring contacts or the second spring contacts are lifted up based on the height difference between the surfaces of the first row of gold fingers and the second row of gold fingers, the first spring contacts and the second spring contacts that are staggered will not contact. Compared with the related art, this avoids an accidental contact situation where the first spring contacts and the second spring contacts, whose distances from the host computer are less than the thickness of the circuit board, are lifted up by the first row of gold fingers and the second row of gold fingers with the height difference on surfaces thereof, thereby reducing the occurrence of dangerous situations and improving the safety of the optical module.

In some examples, the first contact and the second contact are staggered along the arrangement direction of the first row of gold fingers, the first contact is located within a gap between the two adjacent second contacts, or the first contact is located outside the second contact corresponding to an outermost second gold finger in the second row of gold fingers. Thus, the first contact and the second contact are completely staggered, which can effectively prevent accidental contact of the spring contact of the socket after the optical module is removed, and in the case of hot swapping of the optical module, it is ensured that the spring contact of the socket will not be at risk of short circuit.

In some examples, the first contact and the second contact are staggered along the extension direction of the gold fingers; and along the extension direction of the gold fingers, the first contact is located on one side of the second contact. Thus, the space required along the arrangement direction of the gold fingers can be reduced. On one hand, the density of gold finger arrangement can be increased, thereby enhancing the transmission performance of the optical module for high-speed signals; and on the other hand, the occupied width of the circuit board can be reduced, thereby decreasing the overall size of the optical module.

In some examples of the embodiments of the present disclosure, the first contact and the second contact may be staggered along the arrangement direction of the first gold fingers, and the first contact and the second contact are also staggered along the extension direction of the gold fingers. Thus, the flexibility of staggering the gold fingers is improved, and the first row of gold fingers and the second row of gold fingers can be staggered according to actual needs, which facilitates the staggered arrangement of the first contact and the second contact.

In other examples of the embodiments of the present disclosure, along the width direction of the circuit board, the circuit board has a first side surface and a second side surface. Along the arrangement direction of the first row of gold fingers, the first row of gold fingers may be integrally shifted by a preset distance toward the second side surface, such that a first distance between the first row of gold fingers and the first side surface is greater than a second distance between the second gold finger and the second side surface. Along the arrangement direction of the second row of gold fingers, the second row of gold fingers may be integrally shifted by a preset distance toward the first side surface, such that a fourth distance between the second row of gold fingers and the second side surface is greater than a third distance between the second row of gold fingers and the first side surface. In other words, when the first contact and the second contact are staggered, the first row of gold fingers may be shifted by a preset distance, and the second row of gold fingers may also be shifted by a preset distance, where the translation directions of the first row of gold fingers and the second row of gold fingers are opposite. Thus, the translation distances of the first row of gold fingers and the second row of gold fingers are both relatively short, which can reduce the space required in the width direction of the circuit board, helping to reduce the size of the circuit board and the size of the optical module.

In other examples of the embodiments of the present disclosure, a front end of the circuit board is tapered, and the circuit board has a first inclined surface, a second inclined surface, a third inclined surface, and a fourth inclined surface. The first inclined surface is connected between the first side surface and the front end surface of the circuit board, and the second inclined surface is connected between the first surface and the front end surface; the third inclined surface is symmetrically arranged with respect to the first inclined surface; and the fourth inclined surface is symmetrically arranged with respect to the second inclined surface. Thus, when the optical module is inserted into the host computer, the front end of the circuit board is inserted into the socket, and the first inclined surface, the second inclined surface, the third inclined surface, and the fourth inclined surface facilitate insertion between the upper and lower spring contacts, thereby protecting the spring contacts of the socket of the host computer.

According to some embodiments of the present disclosure, an optical module is further provided and includes:
an upper shell,
a lower shell part, covering the upper shell to form a cavity, where an electrical port is formed at one end of the cavity; and
a circuit board, provided in the cavity, where gold fingers are formed at one end of the circuit board, extend out of an electrical port, and are configured to transmit electrical signals;
where the gold fingers include:
   a first row of gold fingers, provided on a first surface of the circuit board, arranged along a width direction of the circuit board, and configured to be electrically connected to a first row of metal spring contacts on a first side wall of a host computer for transmitting the electrical signals;
   a second row of gold fingers, provided on a second surface of the circuit board, arranged along the width direction of the circuit board, and configured to be electrically connected to a second row of metal spring contacts on a second side wall of the host computer for transmitting the electrical signals, where the second surface and the first surface are two opposite surfaces of the circuit board, and the first side wall and the second side wall are two opposite side walls of the host computer, surfaces of the first row of gold fingers and the second row of gold fingers have a height difference, and a distance between the first row of metal spring contacts and the second row of metal spring contacts is less than a thickness of the circuit board;
   a first gold finger in the first row of gold fingers has a first contact, and the first contact is configured to contact a first spring contact in the first row of metal spring contacts; a second gold finger in the second row of gold fingers has a second contact, and the second contact is configured to contact a second spring contact in the second row of metal spring contacts; and the first gold finger and the second gold finger are staggered and partially overlapped, and the first contact and the second contact are arranged in a staggered manner, such that the first spring contact and the second spring contact are staggered;
   along an arrangement direction of the first row of gold fingers, the first contact is located within a gap between the two adjacent second contacts, or the first contact is located outside the second contact corresponding to an outermost second gold finger in the second row of gold fingers;
   and along the extension direction of the gold fingers, the first contact is located on one side of the second contact.

It can be understood that the optical module provided in the embodiments of the present disclosure may have the same or corresponding technical effects as the optical module in the foregoing embodiments of the present disclosure. For details, reference may be made to the detailed description of the foregoing embodiments of the present disclosure. This will not be repeated herein.

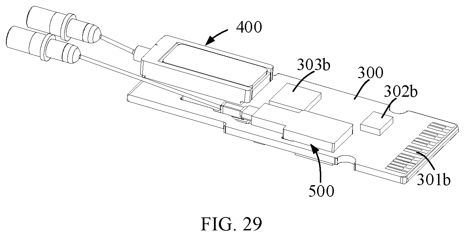

FIG. 29 is a partial structural diagram of an optical module provided according to some embodiments of the present disclosure. As shown in FIG. 29, an MCU 302b and a DSP chip 303b are mounted on the circuit board 300. The DSP chip 303b and the MCU 302b are respectively connected to the gold fingers 301b via signal lines. The electrical signals output by the host computer 100 are transmitted to the DSP chip 303b via the gold fingers 301b. The DSP chip 303b transmits the electrical signals to a laser chip in an optical emission component 400 via the signal lines, such that the laser chip generates optical signals, implementing optical emission.

The optical signals transmitted by an external optical fiber are converted into the electrical signals by an optical reception component 500. The electrical signals are transmitted to the DSP chip 303b via the signal lines. The electrical signals are transmitted to the gold fingers 301b via the signal lines after processed by the DSP chip 303b. The gold fingers 301b transmit the electrical signals to the host computer 100, thereby implementing optical reception.

In some embodiments, an optical communication device transmits the electrical signals mainly by NRZ coding, that is, binary signals composed of two levels, 0 and 1, are used for signal transmission. However, with the advent of the era of big data and cloud computing, higher requirements are placed on the signal transmission rate of the optical communication device. Binary NRZ coding composed of two levels, 0 and 1, is gradually unable to meet the current demand for the high signal transmission rate due to limitations in electrical signal modulation and transmission rate. To meet the current demand for the signal transmission rate, the use of PAM4 type signals for signal transmission has emerged.

Compared with NRZ type signals, PAM4 coding features four digital amplitude levels (such as 0, 1, 2, 3), and at a same baud rate, a bit rate can be up to twice that of NRZ coding, greatly improving the transmission rate.

A 50G optical module is taken as an example, when the host computer 100 transmits the electrical signals to the optical module, three modes can be used: 2×25G NRZ, 1×50G PAM4, and 1×50G NRZ. Since 1×50G NRZ requires a higher bandwidth rate for the circuit board 300, it is currently preferred to use 2×25G NRZ signals or 1×50G PAM4 signals.

In some embodiments, according to the requirements for the transmission rate of the optical module, such as 50Gbs, the electrical signals transmitted between the host computer 100 and the gold fingers 301b may be 2×25G NRZ electrical signals or 1 ×50G PAM4 electrical signals. When the optical module 200 receives the electrical signals transmitted by the host computer 100, the DSP chip 303b can only receive one type of the electrical signals, such as the 2×25G NRZ electrical signals or the 1×50G PAM4 electrical signals, and cannot receive both the 2×25G NRZ electrical signals and the 1×50G PAM4 electrical signals, that is, compatibility between NRZ electrical signals and PAM4 electrical signals cannot be implemented. As a result, the number of optical modules connected to the host computer 100 increases; in terms of usage, when the host computer 100 is switched to output electrical signal coding, the inserted optical module needs to be switched, increasing inconvenience of use. Thus, this solution is not suitable for the development trend of the high signal transmission rate.

To implement compatibility of the optical module with the NRZ electrical signals and the PAM4 electrical signals, the present disclosure provides an optical module, where the DSP chip in the optical module has an NRZ electrical signal processing mode and a PAM4 electrical signal processing mode. The DSP chip transmits the NRZ electrical signals or the PAM4 electrical signals via a signal trace on the circuit board. The MCU controls the DSP chip to switch the electrical signal processing mode according to the type of electrical signals transmitted by the gold fingers, such that the optical module can implement input of the NRZ electrical signals and the PAM4 electrical signals, reducing the number of optical modules and providing convenience for usage. The input of the NRZ electrical signals and the PAM4 electrical signals can be freely switched according to user conditions.

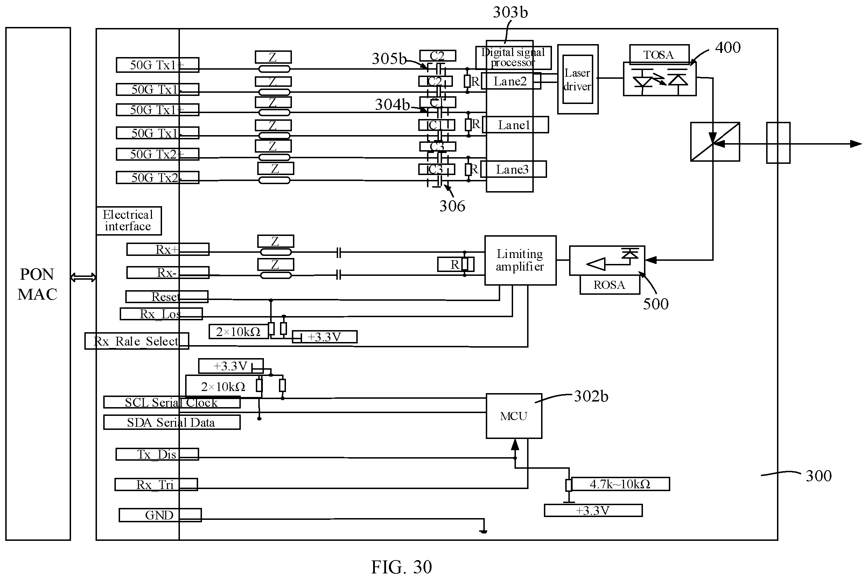

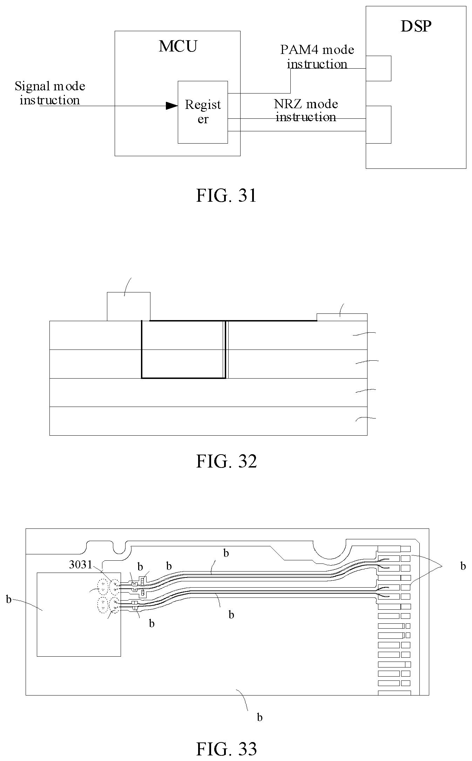

FIG. 30 is a schematic diagram of a signal principle of an optical module provided according to some embodiments of the present disclosure; and FIG. 31 is a block diagram of switching between different electrical signal modes in an optical module provided according to some embodiments of the present disclosure. As shown in FIG. 30 and FIG. 31, to implement compatible input of the NRZ electrical signals and the PAM4 electrical signals in the optical module, a register is provided in the MCU 302b. The MCU 302b modifies the value of the register according to the type of electrical signals transmitted by the gold fingers 301b. For example, when the electrical signals transmitted by the gold fingers 301b are the NRZ electrical signals, the MCU 302b modifies the value of the register to 0, and then sends an NRZ mode instruction to the DSP chip 303b according to the value of the register, such that the DSP chip 303b is switched to the NRZ electrical signal processing mode. Thus, the DSP chip 303b processes the received NRZ electrical signals, and the processed NRZ electrical signals are transmitted to the optical emission component 400, such that the optical emission component 400 generates the optical signals.

When the electrical signals transmitted by the gold fingers 301b are the PAM4 electrical signals, the MCU 302b modifies the value of the register to 1, and then sends a PAM4 mode instruction to the DSP chip 303b according to the value of the register, such that the DSP chip 303b is switched to the PAM4 electrical signal processing mode. Thus, the DSP chip 303b processes the received PAM4 electrical signals, and the processed PAM4 electrical signals are transmitted to the optical emission component 400, such that the optical emission component 400 generates the optical signals.

In some embodiments, to enable the DSP chip 303b to receive the NRZ electrical signals and the PAM4 electrical signals, the DSP chip 303b has a first electrical interface and a second electrical interface. The gold fingers 301b are connected to the first electrical interface or the second electrical interface via the signal trace laid out on the circuit board 300, so as to transmit the NRZ electrical signals or the PAM4 electrical signals to the DSP chip 303b.

In some embodiments, the DSP chip 303b is generally mounted on the circuit board 300 via ball grid array (BGA) packaging, that is, a BGA solder ball is soldered at a bottom surface of the DSP chip 303b. The BGA solder ball can be connected to the electrical interface of the DSP chip 303b via the signal line, and the BGA solder ball is soldered to the surface of the circuit board 300. Thus, the electrical signals transmitted by the circuit board 300 are transmitted to the DSP chip 303b via the BGA solder ball.

FIG. 32 is a schematic diagram of a signal trace between gold fingers and a digital signal processor in an optical module provided according to some embodiments of the present disclosure. As shown in FIG. 32, the circuit board 300 is of a multilayer structure and generally includes a top layer 310b, a bottom layer 340, and an inner layer. The top layer 310b is located on a top surface of the circuit board 300, and the gold fingers 301b are located on the top layer 310b. The bottom layer 340 is located on a bottom surface of the circuit board 300, and the inner layer is located between the top layer 310b and the bottom layer 340. The inner layer may be a single inner layer or at least two inner layers.

For example, the inner layer may include a first inner layer 320 and a second inner layer 330. The first inner layer 320 is located between the top layer 310b and the bottom layer 340, and the second inner layer 330 is located between the first inner layer 320 and the bottom layer 340. The first inner layer 320 serves as a reference layer, a dielectric layer, or a ground layer, and the second inner layer 330 serves as a signal layer.

When the gold fingers 301b transmit the electrical signals to the DSP chip 303b via the signal trace on the circuit board 300, the signal trace may be laid out on the top layer 310b of the circuit board 300. One end of the signal trace is connected to the gold fingers 301b, and the other end thereof is connected to the electrical interface of the DSP chip 303b, so as to transmit the NRZ electrical signals or the PAM4 electrical signals to the DSP chip 303b via the signal trace.

If the electrical interface of the DSP chip 303b is located at an edge of the DSP chip 303b, the signal trace can directly extend to the edge of the DSP chip 303b, and the DSP chip 303b and the signal trace are connected via the BGA solder ball. If the electrical interface of the DSP chip 303b is located on an inner side of the DSP chip 303b, it is inconvenient to lay out the signal trace below the DSP chip 303b, and signal connection between the DSP chip 303b and the circuit board 300 can be implemented through a via.

For example, a first via and a second via are formed between the top layer 310b and the second inner layer 330. The first via is located outside the DSP chip 303b, and the second via is located below the electrical interface of the DSP chip 303b. The signal line is laid out on the second inner layer 330. One end of the first via is connected to the signal trace on the top layer 310b, and the other end of the first via is connected to one end of the signal line. The other end of the signal line is connected to the second via, and the second via is connected to the electrical interface of the DSP chip 303b. Thus, signal connection between the DSP chip 303b and the gold fingers 301b is implemented via the signal trace on the top layer 310b, the first via, the signal line on the second inner layer 330, and the second via.

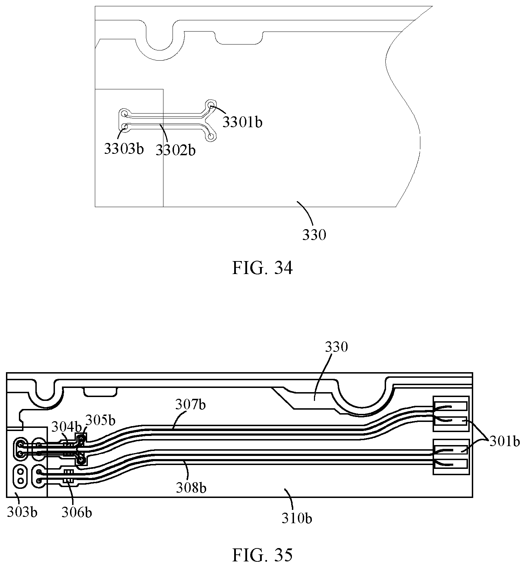

FIG. 33 is a first top layer routing diagram of a circuit board in an optical module provided according to some embodiments of the present disclosure; and FIG. 34 is an inner layer routing diagram of a circuit board in an optical module provided according to some embodiments of the present disclosure. As shown in FIG. 33 and FIG. 34, since the DSP chip 303b can receive the NRZ electrical signals and the PAM4 electrical signals transmitted by the gold fingers 301b, to implement connection between the gold fingers 301b and the first electrical interface and second electrical interface of the DSP chip 303b, the signal trace may be formed on the top layer 310b. One end of the signal trace is connected to the gold fingers 301b, and the other end thereof is directly connected to the first electrical interface, such that the first electrical signals transmitted by the gold fingers 301b are transmitted to the DSP chip 303b via the signal trace on the top layer 310b. The first electrical signals may be the 2×25G NRZ electrical signals.

Since the NRZ electrical signals transmitted by the gold fingers 301b are the 2×25G NRZ electrical signals, to transmit the 2×25G NRZ electrical signals to the DSP chip 303b via the signal trace, the first electrical interface of the DSP chip 303b includes a first electrical channel 3031 and a second electrical channel 3033. The signal trace on the top layer 310b includes a first signal trace 307b and a second signal trace 308b. One end of the first signal trace 307b is connected to the gold fingers 301b, and the other end of the first signal trace 307b extends to an edge of the DSP chip 303b. The first signal trace 307b is connected to the first electrical channel 3031, such that 1×25G NRZ electrical signals are transmitted to the DSP chip 303b via the first signal trace 307b.

One end of the second signal trace 308b is connected to the gold fingers 301b, and the other end of the second signal trace 308b extends to the edge of the DSP chip 303b. The second signal trace 308b is connected to the second electrical channel 303b3, such that the 1×25G NRZ electrical signals are transmitted to the DSP chip 303b via the second signal trace 308b.

In some embodiments, the first signal trace 307b and the second signal trace 308b may be arranged side by side on the top layer 310b, and the first electrical channel 3031 and the second electrical channel 3033 are arranged side by side at the edge of the DSP chip 303b. Thus, the 2×25G NRZ electrical signals are directly transmitted to the DSP chip 303b via the first signal trace 307b and the second signal trace 308b. After receiving the 2×25G NRZ electrical signals via the first electrical channel 3031 and the second electrical channel 3033, the DSP chip 303b processes the 2×25G NRZ electrical signals in the NRZ electrical signal processing mode, and the processed 2×25G NRZ electrical signals are transmitted to the optical emission component 400, such that the optical emission component 400 generates the optical signals.

In some embodiments, there may be clutters in the 2×25G NRZ electrical signals transmitted by the gold fingers 301b. To filter out the clutters, a first capacitor 304b and a second capacitor 306b are also formed on the top layer 310b. The first signal trace 307b passes through the first capacitor 304b and is connected to the first electrical channel 3031. Thus, the 1×25G NRZ electrical signals transmitted by the gold fingers 301b are filtered by the first capacitor 304b and then transmitted to the DSP chip 303b via the first signal trace 307b.

The second signal trace 308b passes through the second capacitor 306b and is connected to the second electrical channel 303b3. Thus, the 1×25G NRZ electrical signals transmitted by the gold fingers 301b are filtered by the second capacitor 306b and then transmitted to the DSP chip 303b via the second signal trace 308b, and the 2×25G NRZ electrical signals are transmitted to the DSP chip 303b via the first signal trace 307b and the second signal trace 308b.

In some embodiments, a third signal trace may also be formed on the top layer 310b. The third signal trace may be arranged side by side with the first signal trace 307b and the second signal trace 308b. Both ends of the third signal trace are connected to the gold fingers 301b and the DSP chip 303b. The third signal trace is configured to transmit second electrical signals that may be the 1×50G PAM4 electrical signals.

The second electrical interface 3032 may be located at the edge of the DSP chip 303b. In this case, the third signal trace is connected to the second electrical interface 3032. The 1×50G PAM4 electrical signals transmitted by the gold fingers 301b are transmitted to the DSP chip 303b via the third signal trace. After receiving the 1×50G PAM4 electrical signals via the second electrical interface 3032, the DSP chip 303b processes the 1×50G PAM4 electrical signals in the PAM4 electrical signal processing mode, and the processed 1×50G PAM4 electrical signals are transmitted to the optical emission component 400, such that the optical emission component 400 generates the optical signals.

In some embodiments, the second electrical interface 3032 may also be located on the inner side of the DSP chip 303b. In this case, a signal transmission line is laid out on one inner layer, and the first via is formed between the top layer 310b and the inner layer. The third signal trace extends from the gold fingers 301b to the first via. The third signal trace is connected to one end of the signal transmission line via the first via. The 1×50G PAM4 electrical signals transmitted by the gold fingers 301b are transmitted to the signal transmission line on the inner layer via the third signal trace and the first via.

The second via is formed between the second electrical interface 3032 of the DSP chip 303b and the inner layer where the signal transmission line is located. The signal transmission line on the inner layer is connected to the second electrical interface 3032 via the second via. The 1×50G PAM4 electrical signals transmitted by the signal transmission line on the inner layer are transmitted to the DSP chip 303b via the second via. After receiving the 1×50G PAM4 electrical signals via the second electrical interface 3032, the DSP chip 303b processes the 1×50G PAM4 electrical signals in the PAM4 electrical signal processing mode, and the processed 1×50G PAM4 electrical signals are transmitted to the optical emission component 400, such that the optical emission component 400 generates the optical signals.

To filter out clutters in the 1×50G PAM4 electrical signals transmitted by the gold fingers 301b, a third capacitor 305b is also formed on the top layer 310b. The third signal trace passes through the third capacitor 305b and is connected to the first via. Thus, the 1×50G PAM4 electrical signals transmitted by the gold fingers 301b are filtered by the third capacitor 305b and then transmitted to the DSP chip 303b via the first via, the signal transmission line, and the second via.

In some embodiments, referring to FIG. 34, the inner layer includes the second inner layer 330. The first via 3301b is formed between the second inner layer 330 and the top layer 310b, and the first via 3301b is located on the outer side of the DSP chip 303b. The signal transmission line 3302b is laid out on the second inner layer 330. The second via 3303b is formed between the second inner layer 330 and the second electrical interface 303b2 of the DSP chip 303b. One end of the signal transmission line 3302b is connected to the first via 3301b, and the other end of the signal transmission line 3302b is connected to the second via 3303b.

Thus, the 1×50G PAM4 electrical signals transmitted by the third signal trace are filtered by the third capacitor 305b. The filtered 1×50G PAM4 electrical signals are transmitted to the signal transmission line 3302b via the first via 3301b. The 1×50G PAM4 electrical signals transmitted by the signal transmission line 3302b are transmitted to the second electrical interface 3032 of the DSP chip 303b via the second via 3303b, thereby transmitting the 1×50G PAM4 electrical signals to the DSP chip 303b.

In some embodiments, in order to reduce the loss of the electrical signals caused by the signal trace, the first signal trace 307b, the second signal trace 308b, and the third signal trace are located on the top layer 310b. However, the arrangement of the first signal trace 307b, the second signal trace 308b, and the third signal trace on the top layer 310b occupies most of the area of the top layer 310b, which is not conducive to arranging other components on the top layer 310b.

In order to reduce the area occupied by the signal trace, the first signal trace 307b and the third signal trace, or the second signal trace 308b and the third signal trace, may be configured as a same signal trace. For example, the first signal trace 307b and the third signal trace are the same signal trace, which branches at one end of the first signal trace 307b close to the DSP chip 303b. One branch passes through the first capacitor 304b and is connected to the first electrical interface of the DSP chip 303b, such that the branch is configured to transmit the first electrical signals; and another branch passes through the third capacitor 305b and is connected to the second electrical interface of the DSP chip 303b, such that t the branch is configured to transmit the second electrical signals.

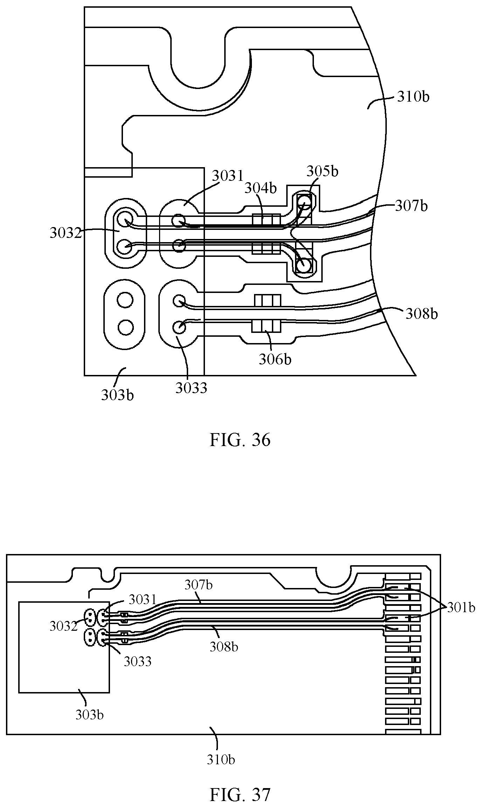

FIG. 35 is a top view of routing of a circuit board in an optical module provided according to some embodiments of the present disclosure; and FIG. 36 is a top view of partial routing of a circuit board in an optical module provided according to some embodiments of the present disclosure. As shown in FIG. 35 and FIG. 36, one end of the first signal trace 307b close to the DSP chip 303b includes a first branch trace and a second branch trace. The first branch trace passes through the first capacitor 304b and is connected to the first electrical interface of the DSP chip 303b, and is configured to transmit the first electrical signals; the second branch trace passes through the third capacitor 305b and is connected to the second electrical interface of the DSP chip 303b, and is configured to transmit the second electrical signals. Thus, the first signal trace can transmit both the first electrical signals and the second electrical signals, where the first electrical signals are the NRZ electrical signals and the second electrical signals are the PAM4 electrical signals.

When the host computer 100 transmits the NRZ electrical signals to the gold finger 301b, the first signal trace 307b transmits the 1×25G NRZ electrical signals. The 1×25G NRZ electrical signals sequentially pass through the third capacitor 305b and the first capacitor 304b for filtering. The filtered 1×25G NRZ electrical signals are transmitted to the first electrical channel 3031 of the DSP chip 303b along the first branch trace. The 1×25G NRZ electrical signals transmitted by the second signal trace 308b pass through the second capacitor 306b. After filtered by the second capacitor 306b, the 1×25G NRZ electrical signals are transmitted to the second electrical channel 3033 of the DSP chip 303b. Thus, the 2×25G NRZ electrical signals are transmitted to the DSP chip 303b via the first signal trace 307b and the second signal trace 308b.

When the host computer 100 transmits the PAM4 electrical signals to the gold finger 301b, the first signal trace 307b transmits the 1×50G PAM4 electrical signals. The 1×50G PAM4 electrical signals pass through the third capacitor 305b for filtering, and the filtered 1×50G PAM4 electrical signals are transmitted along the second branch trace. The 1×50G PAM4 electrical signals transmitted by the second branch trace pass through the first via 3301b and are transmitted to the signal transmission line 3302b, and the 1×50G PAM4 electrical signals are transmitted to the second electrical interface 3032 of the DSP chip 303b through the signal transmission line 3302b and the second via 3303b. Thus, the 1×50G PAM4 electrical signals are transmitted to the DSP chip 303b via the first signal trace 307b.

In some embodiments, the second branch trace at one end of the first signal trace 307b can also transmit the 1×25G NRZ electrical signals. One end of the second signal trace 308b close to the DSP chip 303b is connected to the second electrical channel 303b3 through the via and an inner signal transmission line; and the first branch trace at one end of the first signal trace 307b can also transmit the 1×50G PAM4 electrical signals.

Since the first electrical signals are the 2×25G NRZ electrical signals and the second electrical signals are the 1×50G PAM4 electrical signals, and the transmission rate of the first electrical signal is lower than the transmission rate of the second electrical signal, in order to reduce loss, the first electrical signals are transmitted to the DSP chip 303b along the first branch trace of the first signal trace 307b and the second signal trace 308b, thereby transmitting the 2×25G NRZ electrical signals to the DSP chip 303b; and the second electrical signals are transmitted to the DSP chip 303b along the second branch trace of the first signal trace 307b, thereby transmitting the 1×50G PAM4 electrical signals to the DSP chip 303b.

In some embodiments, when the 1×25G NRZ electrical signals or the 1×50G PAM4 electrical signals are transmitted via the first signal trace 307b, to enable the NRZ electrical signals to be input to the DSP chip 303b through the first electrical interface and the PAM4 electrical signals to be input to the DSP chip 303b through the second electrical interface 3032, the DSP chip 303b can control the connection and disconnection of the first electrical interface and the second electrical interface 3032 according to the value of the register in the MCU 302b.

When the host computer 100 outputs the NRZ electrical signals, the MCU 302b modifies the value of the register to a first value, such as 0, and then the MCU 302b sends the NRZ mode instruction to the DSP chip 303b. After receiving the NRZ mode instruction, the DSP chip 303b controls connection of the first electrical interface and disconnection of the second electrical interface 303b2, and switches an operating mode to the NRZ electrical signal processing mode. Thus, the 1×25G NRZ electrical signals transmitted by the first signal trace 307b pass through the third capacitor 305b and the first capacitor 304b, are transmitted to the first electrical channel 303b1 along the first branch trace, and are input to the DSP chip 303b via the first electrical channel 303b1.

In some embodiments, the 1×25G NRZ electrical signals transmitted by the first signal trace 307b can be transmitted to the second electrical interface 3032 along the second branch trace through the third capacitor 305b, the first via 3301b, the signal transmission line 3302b and the second via 3303b. Since the second electrical interface 3032 is disconnected, the 1×25G NRZ electrical signals cannot be input to the DSP chip 303b via the second electrical interface 3032.

Meanwhile, the 1×25G NRZ electrical signals transmitted by the second signal trace 308b pass through the second capacitor 306b and are transmitted to the second electrical channel 3033, and the 1×25G NRZ electrical signals are input to the DSP chip 303b via the second electrical channel 303b3. After the 2×25G NRZ electrical signals are input to the DSP chip 303b, the DSP chip 303b processes the 2×25G NRZ electrical signals in the NRZ electrical signal processing mode, and the processed electrical signals are transmitted to the optical emission component 400, such that the optical emission component 400 generates the optical signals.

When the host computer outputs the PAM4 electrical signals, the MCU 302b modifies the value of the register to a second value, such as 1, and then the MCU 302b sends the PAM4 mode instruction to the DSP chip 303b. After receiving the PAM4 mode instruction, the DSP chip 303b controls disconnection of the first electrical interface and connection of the second electrical interface 3032, and switches the operating mode to the PAM4 electrical signal processing mode. Thus, the 1×50G PAM4 electrical signals transmitted by the first signal trace 307b are transmitted to the second electrical interface 3032 along the second branch trace through the third capacitor 305b, the first via 3301b, the signal transmission line 3302b, and the second via 3303b, and the 1×50G PAM4 electrical signals are input to the DSP chip 303b via the second electrical interface 3032.

After the 1×50G PAM4 electrical signals are input to the DSP chip 303b, the DSP chip 303b processes the 1×50G PAM4 electrical signals in the PAM4 electrical signal processing mode, and the processed electrical signals are transmitted to the optical emission component 400, such that the optical emission component 400 generates the optical signals.

In some embodiments, the 1×50G PAM4 electrical signals transmitted by the first signal trace 307b can sequentially pass through the third capacitor 305b and the first capacitor 304b and be transmitted to the first electrical channel 3031 along the first branch trace. Since the first electrical channel 3031 is disconnected, the 1×50G PAM4 electrical signals cannot be input to the DSP chip 303b via the first electrical channel 3031.

In some embodiments, the first electrical interface and second electrical interface 3032 of the DSP chip 303b may also always be in a connection state, where the first electrical interface is configured to transmit only the NRZ electrical signals, and the second electrical interface 3032 is configured to transmit only the PAM4 electrical signals. When the host computer outputs the NRZ electrical signals, the MCU 302b modifies the value of the register to 0, the MCU 302b sends the NRZ mode instruction to the DSP chip 303b, and the DSP chip 303b switches the operating mode to the NRZ electrical signal processing mode.

The 1×25G NRZ electrical signals transmitted by the first signal trace 307b pass through the third capacitor 305b and the first capacitor 304b and are transmitted to the first electrical channel 3031 along the first branch trace, and the 1×25G NRZ electrical signals are input to the DSP chip 303b via the first electrical channel 3031; the 1×25G NRZ electrical signals transmitted by the first signal trace 307b are also transmitted to the second electrical interface 3032 along the second branch trace through the third capacitor 305b, the first via 3301b, the signal transmission line 3302b, and the second via 3303b. Since the second electrical interface 3032 only transmits the PAM4 electrical signals, the 1×25G NRZ electrical signals cannot be input to the DSP chip 303b via the second electrical interface 3032.

When the host computer outputs the PAM4 electrical signals, the MCU 302b modifies the value of the register to 1, the MCU 302b sends the PAM4 mode instruction to the DSP chip 303b. After receiving the PAM4 mode instruction, the DSP chip 303b switches the operating mode to the PAM4 electrical signal processing mode.

The 1×50G PAM4 electrical signals transmitted by the first signal trace 307b are transmitted to the second electrical interface 3032 along the second branch trace through the third capacitor 305b, the first via 3301b, the signal transmission line 3302b, and the second via 3303b, and the 1×50G PAM4 electrical signals are input to the DSP chip 303b via the second electrical interface 3032.

The 1×50G PAM4 electrical signals transmitted by the first signal trace 307b also pass through the third capacitor 305b and the first capacitor 304b and are transmitted to the first electrical channel 3031 along the first branch trace. Since the first electrical interface only transmits the NRZ electrical signals, the 1×50G PAM4 electrical signals cannot be input to the DSP chip 303b via the first electrical channel 3031.

In some embodiments, the signal traces for transmitting the NRZ electrical signals and the PAM4 electrical signals may also be laid out on other layers of the circuit board 300. For example, the signal trace for transmitting the NRZ electrical signals may be laid out on the top layer 310b, and the signal trace for transmitting the PAM4 electrical signals may be laid out on the bottom layer 340.

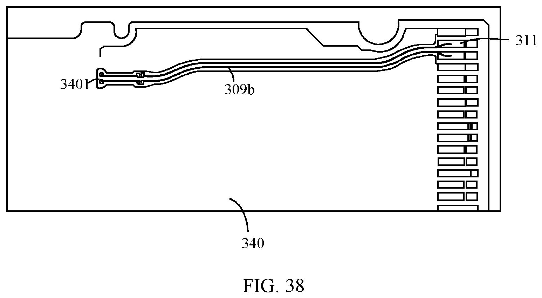

FIG. 37 is a second top layer routing diagram of a circuit board in an optical module provided according to some embodiments of the present disclosure; and FIG. 38 is a bottom layer routing diagram of a circuit board in an optical module provided according to some embodiments of the present disclosure. As shown in FIG. 37 and FIG. 38, the top layer 310b of the circuit board 300 is provided with the first gold finger 301b and a first signal line. The first signal line includes the first signal trace 307b and the second signal trace 308b that are respectively connected to the first gold finger 301b. The first signal trace 307b and the second signal trace 308b extend from the first gold finger 301b to the first electrical interface of the DSP chip 303b. The first signal trace 307b is directly connected to the first electrical channel 303b1 and is configured to transmit the 1×25G NRZ electrical signals; the second signal trace 308b is directly connected to the second electrical channel 303b3 and is configured to transmit the 1×25G NRZ electrical signals. Thus, the 2×25G NRZ electrical signals output by the host computer 100 are transmitted to the DSP chip 303b via the first signal trace 307b and the second signal trace 308b.

After the DSP chip 303b receives the 2×25G NRZ electrical signals transmitted by the first signal trace 307b and the second signal trace 308b, the DSP chip 303b processes the 2×25G NRZ electrical signals in the NRZ electrical signal processing mode, and the processed electrical signals are transmitted to the optical emission component 400, such that the optical emission component 400 generates the optical signals.

Referring to FIG. 38, the bottom layer 340 of the circuit board 300 is provided with the second gold finger 311 and a second signal line 309b. A via 3401 is provided between the bottom layer 340 and the top layer 310b. One end of the second signal line 309b is connected to the second gold finger 311, and the other end of the second signal line 309b is connected to one end of the via 3401. The other end of the via 3401 is connected to the second electrical interface 303b2. Thus, when the host computer 100 outputs the PAM4 electrical signals, the second gold finger 311 transmits the 1×50G PAM4 electrical signals to the second electrical interface 303b2 via the second signal line 309b and the via 3401, such that the 1×50G PAM4 electrical signals are input to the DSP chip 303b via the second electrical interface 303b2.

In some embodiments, the signal trace for transmitting the NRZ electrical signals may also be laid out on the bottom layer 340, and the signal trace for transmitting the PAM4 electrical signals may also be laid out on the top layer 310b. As long as the NRZ electrical signals or the PAM4 electrical signals transmitted by the host computer 100 can be transmitted to the DSP chip 303b, the DSP chip 303b processes the NRZ electrical signals or the PAM4 electrical signals in corresponding electrical signal processing modes, such that the optical module can compatibly input the NRZ electrical signals and the PAM4 electrical signals.

In the optical module provided by the present disclosure, the DSP chip has the NRZ electrical signal processing mode and the PAM4 electrical signal processing mode. The NRZ electrical signals or the PAM4 electrical signals are transmitted to the DSP chip via the signal traces on the circuit board. The DSP chip processes the received NRZ electrical signals in the NRZ electrical signal processing mode, or processes the received PAM4 electrical signals in the PAM4 electrical signal processing mode, such that the optical module can compatibly input the NRZ electrical signals and the PAM4 electrical signals, reducing the number of optical modules inserted into the host computer and enhancing product competitiveness with a compatible optical module. In terms of usage, users can freely switch input modes of the NRZ electrical signals and the PAM4 electrical signals according to their usage conditions, improving usage convenience.

Finally, it should be noted that the above embodiments are provided merely to illustrate the technical solutions of the present disclosure and not to limit them. Although the present disclosure has been described in detail with reference to the aforementioned embodiments, those of ordinary skill in the art should understand that they can still make modifications on the technical solutions described in the aforementioned embodiments or make equivalent replacements on some of the technical features; and these modifications or replacements do not make the essence of the corresponding technical solutions depart from the spirit and scope of the technical solutions of the various embodiments of the present disclosure.

## Claims

1. An optical module, comprising:
a circuit board;
wherein gold fingers are formed at one end of the circuit board, the gold fingers are configured to transmit electrical signals, and the gold fingers comprise first gold fingers and second gold fingers; and the circuit board comprises:
a first metal surface layer, located on an upper surface of the circuit board and provided with the first gold fingers, wherein surfaces of the first gold fingers are configured to connect to spring contacts to implement electrical connection, a gap is provided on one side of the first gold fingers, and the first gold fingers comprise high-frequency signal gold fingers;
a second metal surface layer, located on a lower surface of the circuit board and provided with the second gold fingers; and
a first metal intermediate layer, located between the first metal surface layer and the second metal surface layer and located below the first metal surface layer, wherein a first insulating support layer is provided between the first metal intermediate layer and the first metal surface layer, a metal layer is absent from the first metal intermediate layer within a projection area of the high-frequency signal gold fingers, and a first insulating support layer within the projection area on one side of the high-frequency signal gold fingers is hollowed out;
the first gold fingers are arranged along a width direction of the circuit board to form a first row of gold fingers, the first row of gold fingers is configured to be electrically connected to a first row of metal spring contacts on a first side wall of a host computer to transmit the electrical signals, and the first row of metal spring contacts comprise the spring contacts;
the second gold fingers are arranged along a width direction of the circuit board to form a second row of gold fingers, the second row of gold fingers is configured to be electrically connected to the second row of metal spring contacts on a second side wall of the host computer to transmit the electrical signals, and the first side wall and the second side wall are two opposite side walls of the host computer, wherein surfaces of the first row of gold fingers and surfaces of the second row of gold fingers have a height difference, and a spacing between the first row of metal spring contacts and the second row of metal spring contacts is less than a thickness of the circuit board;
the first gold fingers have first contacts, the first contacts are configured to contact first spring contacts of the first row of gold fingers; the second gold fingers have second contacts, the second contacts are configured to contact second spring contacts of the second row of metal spring contacts; and the first contacts and the second contacts are arranged in a staggered manner, such that the first spring contacts and the second spring contacts are staggered.

2. The optical module according to claim 1, **characterized in that** a second insulating support layer within the projection area on one side of the high-frequency signal gold fingers is hollowed out, and a second insulating support layer within the projection area of the high-frequency signal gold fingers is hollowed out, wherein the second insulating support layer is connected to the first metal intermediate layer and is located below the first metal intermediate layer.

3. The optical module according to claim 1, **characterized in that** the first insulating support layer within a projection area between the high-frequency signal gold fingers and an edge of the circuit board is hollowed out.

4. The optical module according to claim 1, further comprising at least one metal intermediate layer;
wherein the at least one metal intermediate layer is located between the first metal intermediate layer and the second metal surface layer, and is connected to the first metal intermediate layer via an insulating support layer; the at least one metal intermediate layer within the projection area of the high-frequency signal gold fingers, starting from a first layer from top to bottom in sequence, has at least one layer without a metal layer; and all insulating support layers above a first metal layer within the projection area on one side of the high-frequency signal gold fingers are hollowed out, wherein a first metal layer within the projection area on one side of the high-frequency signal gold fingers and the first metal layer within the projection area on one side of the high-frequency signal gold fingers are located on a same layer of the circuit board.

5. The optical module according to claim 1, **characterized in that** a first insulating support layer within a projection area on the other side of the high-frequency signal gold fingers is hollowed out.

6. The optical module according to claim 1, **characterized in that** the first insulating support layer within the projection area on one side of the high-frequency signal gold fingers is hollowed out to form a first groove, and both ends of the first groove are flush with both ends of a projection area of the spring contacts on the high-frequency signal gold fingers, respectively.

7. The optical module according to claim 1, **characterized in that** the first insulating support layer within the projection area on one side of the high-frequency signal gold fingers is hollowed out to form a first groove, the first groove comprises at least one recessed portion, and a width of the recessed portion is a width of a gap between gold fingers on both sides of the recessed portion.

8. The optical module according to claim 7, **characterized in that** a bottom surface of the first groove is the metal layer; in the projection area of the high-frequency signal gold fingers, the metal layer is absent between the high-frequency signal gold fingers and the metal layer at the bottom surface of the first groove; the high-frequency signal gold fingers are provided on a surface of the first insulating support layer;
the second metal surface layer is located on the lower surface of the circuit board; and the metal layer at the bottom surface of the first groove is located between the first metal surface layer and the second metal surface layer.

9. The optical module according to claim 8, **characterized in that** in the projection area of the high-frequency signal gold fingers, an insulating support layer is absent between the first insulating support layer and the metal layer at the bottom surface of the first groove.

10. The optical module according to claim 8, **characterized in that** a third groove is provided between the high-frequency signal gold fingers and an edge of the circuit board, and a bottom surface of the third groove is the metal layer.

11. The optical module according to claim 1, further comprising:
an upper shell,
a lower shell, covering the upper shell to form a cavity, wherein an electrical port is formed at one end of the cavity,
the circuit board is provided in the cavity, and the gold fingers extend out of the electrical port.

12. The optical module according to claim 11, **characterized in that** the first gold fingers and the second gold fingers are staggered along a width direction of the circuit board, such that the first contacts and the second contacts are staggered along an arrangement direction of the first row of gold fingers; and
along the arrangement direction of the first row of gold fingers, the first contacts are located within a gap between the two adjacent second contacts; or the first contacts are located outside the second contacts corresponding to the outermost second gold fingers in the second row of gold fingers, such that when the circuit board is removed from between the first spring contacts and the second spring contacts, along the arrangement direction of the first row of gold fingers, the first spring contacts are located between the two adjacent second spring contacts, or the first spring contacts are located outside the outermost second spring contacts in the second row of metal spring contacts.

13. The optical module according to claim 11, **characterized in that** the first gold fingers and the second gold fingers are arranged along a length direction of the circuit board, such that the first contacts and the second contacts are staggered along an extension direction of the gold fingers; and
along the extension direction of the gold fingers, the first contacts are located on one side of the second contacts, such that when the circuit board is removed from between the first spring contacts and the second spring contacts, along the extension direction of the gold fingers, the first spring contacts are located on one side of the second spring contacts.

14. The optical module according to claim 1, **characterized in that** the first gold fingers and the second gold fingers are staggered along a width direction of the circuit board, such that the first contacts and the second contacts are staggered along an arrangement direction of the first row of gold fingers; and
along the arrangement direction of the first row of gold fingers, the first contacts are located within a gap between the two adjacent second contacts; or the first contacts are located outside the second contacts corresponding to the outermost second gold fingers in the second row of gold fingers, such that when the circuit board is removed from between the first spring contacts and the second spring contacts, along the arrangement direction of the first row of gold fingers, the first spring contacts are located between the two adjacent second spring contacts, or the first spring contacts are located outside the outermost second spring contacts in the second row of metal spring contacts;
the first gold fingers and the second gold fingers are arranged along a length direction of the circuit board, such that the first contacts and the second contacts are staggered along an extension direction of the gold fingers; and
along the extension direction of the gold fingers, the first contacts are located on one side of the second contacts, such that when the circuit board is removed from between the first spring contacts and the second spring contacts, along the extension direction of the gold fingers, the first spring contacts are located on one side of the second spring contacts.

15. The optical module according to any one of claims 11 to 14, **characterized in that** along the width direction of the circuit board, the circuit board has a first side surface and a second side surface;
along an arrangement direction of the first row of gold fingers, a first gold finger in the first row of gold fingers facing the first side surface has a first distance from the first side surface, a first gold finger in the first row of gold fingers facing the second side surface has a second distance from the second side surface, and the first distance is greater than the second distance;
along an arrangement direction of the second row of gold fingers, a second gold finger in the second row of gold fingers facing the first side surface has a third distance from the first side surface, a second gold finger in the second row of gold fingers facing the second side surface has a fourth distance from the second side surface, and the fourth distance is greater than the third distance; and
the first distance is greater than the third distance, and the fourth distance is greater than the second distance.

16. The optical module according to claim 15, **characterized in that** the first distance and the second distance have a first difference value, and the fourth distance and the third distance have a second difference value;
the first contacts and the second contacts are staggered along the arrangement direction of the first row of gold fingers; and a staggered distance between the first contacts and the second contacts is a sum of the first difference value and the second difference value.

17. The optical module according to claim 15, **characterized in that** a front end of the circuit board is tapered, and the circuit board further has a first inclined surface, a second inclined surface, a third inclined surface, and a fourth inclined surface;
the first inclined surface is connected between the first side surface and a front end surface of the circuit board, the second inclined surface is connected between a first surface and the front end surface, the third inclined surface is connected between the second side surface and the front end surface, and the fourth inclined surface is connected between a second surface and the front end surface; the first row of gold fingers is located at a rear end of the second inclined surface, and the second row of gold fingers is located at a rear end of the fourth inclined surface; and the upper surface is configured as the first surface, and the lower surface is configured as the second surface.

18. The optical module according to claim 17, **characterized in that** the first side surface and the front end surface form a first chamfer at the first inclined surface, and a size of the first chamfer along the width direction of the circuit board is 0.25mm-0.45mm;
the second side surface and the front end surface form a second chamfer at the third inclined surface, and the second chamfer is symmetrical with the first chamfer;
the first surface and the front end surface form a third chamfer at the second inclined surface, and a size of the third chamfer along a length direction of the circuit board is 0.15mm-0.35mm; and
the second surface and the front end surface form a fourth chamfer at the fourth inclined surface, and the fourth chamfer is symmetrical with the third chamfer.

19. The optical module according to any one of claims 11 to 14, **characterized in that** a width of the first gold fingers is the same as a width of the second gold fingers, a first gap is provided between the two adjacent first gold fingers, and a second gap is provided between the two adjacent second gold fingers; and
the width of the first gold fingers is greater than the second gap, and the width of the second gold fingers is greater than the first gap.

20. The optical module according to claim 1, **characterized in that** the circuit board comprises:
a top layer, located on a top surface of the circuit board, wherein the gold fingers are provided on the top layer, signal traces are formed on the top layer and connected to the gold fingers, the signal traces are configured to transmit a first electrical signal or a second electrical signal, a transmission rate of the first electrical signal is different from a transmission rate of the second electrical signal; the first metal surface layer is configured as the top layer, and the upper surface is configured as the top surfaced;
a bottom layer, located on a bottom surface of the circuit board, wherein the second metal surface layer is configured as the bottom layer;
an inner layer, located between the top layer and the bottom layer, wherein a signal transmission line is laid out on the inner layer and connected to the signal traces via vias; the inner layer comprises the first metal intermediate layer;
an MCU, mounted on the top layer, wherein a register is provided in the MCU, the MCU is configured to modify a value of the register according to a type of the electrical signals transmitted by the gold fingers;
a digital signal processor, mounted on the top layer and connected to the MCU, wherein the digital signal processor comprises at least two electrical signal processing modes, the digital signal processor is configured to switch the electrical signal processing modes according to the value of the register in the MCU; and the digital signal processor comprises a first electrical interface and a second electrical interface, the signal traces are directly connected to the first electrical interface, the signal traces are connected to the signal transmission line and the second electrical interface via the vias, the first electrical interface is configured to transmit the first electrical signal, and the second electrical interface is configured to transmit the second electrical signal.

21. The optical module according to claim 20, **characterized in that** the signal traces comprise a first signal trace and a second signal trace, the first signal trace and the second signal trace are arranged side by side; an end of the first signal trace, close to the digital signal processor, comprises a first branch trace and a second branch trace; the second branch trace is connected to the signal transmission line via the vias, and the second branch trace is configured to transmit the second electrical signal;
the first electrical interface comprises a first electrical channel and a second electrical channel, the first branch trace is directly connected to the first electrical channel, the second signal trace is directly connected to the second electrical channel, the first branch trace and the second signal trace are configured to transmit the first electrical signal, and the transmission rate of the first electrical signal is less than the transmission rate of the second electrical signal.

22. The optical module according to claim 21, **characterized in that** a first capacitor and a third capacitor are further formed on the top layer, the first capacitor is connected to the first branch trace, the third capacitor is connected to the second branch trace, the first branch trace passes through the third capacitor and is connected to the first electrical channel, and the second branch trace passes through the third capacitor and is connected to the vias and the signal transmission line.

23. The optical module according to claim 20, **characterized in that** the signal traces comprise the first signal trace, the second signal trace and a third signal trace; the first signal trace, the second signal trace and the third signal trace are arranged side by side, and the third signal trace is connected to the signal transmission line and the second electrical interface via the vias; and
the first electrical interface comprises the first electrical channel and the second electrical channel, the first signal trace is directly connected to the first electrical channel, and the second signal trace is directly connected to the second electrical channel.

24. The optical module according to claim 20, **characterized in that** the digital signal processor controls connection and disconnection of the first electrical interface and the second electrical interface according to the value of the register in the MCU.

25. The optical module according to claim 24, **characterized in that** when the value of the register in the MCU is a first value, the digital signal processor controls the first electrical interface to be connected and the second electrical interface to be disconnected; or
when the value of the register in the MCU is a second value, the digital signal processor controls the first electrical interface to be disconnected and the second electrical interface to be connected.

26. The optical module according to claim 20, **characterized in that** the first electrical interface is located at an edge of the digital signal processor, and the second electrical interface is located at an inner side of the digital signal processor.

27. The optical module according to claim 20, **characterized in that** the first electrical signal is an NRZ electrical signal, and the second electrical signal is a PAM4 electrical signal.

28. An optical module, comprising:
a circuit board;
wherein the circuit board comprises:
a first metal surface layer, located on an upper surface of the circuit board and provided with gold fingers, wherein surfaces of the gold fingers are configured to connect to spring contacts to implement electrical connection; a gap is provided on one side of the gold fingers; and the gold fingers comprise high-frequency signal gold fingers;
a second metal surface layer, located on a lower surface of the circuit board; and
a first metal intermediate layer, located between the first metal surface layer and the second metal surface layer and below the first metal surface layer, wherein a first insulating support layer is provided between the first metal intermediate layer and the first metal surface layer, a metal layer is absent from the first metal intermediate layer within a projection area of the high-frequency signal gold fingers, and a first insulating support layer within the projection area on one side of the high-frequency signal gold fingers is hollowed out.

29. The optical module according to claim 28, **characterized in that** a second insulating support layer within the projection area on one side of the high-frequency signal gold fingers is hollowed out, and a second insulating support layer within the projection area of the high-frequency signal gold fingers is hollowed out; and the second insulating support layer is connected to the first metal intermediate layer and located below the first metal intermediate layer.

30. The optical module according to claim 28, **characterized in that** a first insulating support layer within a projection area between the high-frequency signal gold fingers and an edge of the circuit board is hollowed out.

31. The optical module according to claim 28, further comprising at least one metal intermediate layer; the at least one metal intermediate layer is located between the first metal intermediate layer and the second metal surface layer and connected to the first metal intermediate layer via an insulating support layer; for the at least one metal intermediate layer within the projection area of the high-frequency signal gold fingers, at least one layer starting from the first layer is absent from a metal layer from top to bottom; all insulating support layers above the first metal layer within the projection area on one side of the high-frequency signal gold fingers are hollowed out; and the first metal layer within the projection area of the high-frequency signal gold fingers and the first metal layer within the projection area on one side of the high-frequency signal gold fingers are located on a same layer of the circuit board.

32. The optical module according to claim 28, **characterized in that** a first insulating support layer within a projection area on the other side of the high-frequency signal gold fingers is hollowed out.

33. The optical module according to claim 28, **characterized in that** the first insulating support layer within the projection area on one side of the high-frequency signal gold fingers is hollowed out to form a first groove, and both ends of the first groove are flush with both ends of the spring contacts within the projection area of the high-frequency signal gold fingers.

34. The optical module according to claim 28, **characterized in that** the first insulating support layer within the projection area on one side of the high-frequency signal gold fingers is hollowed out to form a first groove, the first groove comprises at least one recessed portion, and a width of the recessed portion is equal to a width of the gap between the gold fingers on both sides of the recessed portion.
